(19) Europäisches Patentamt
European Patent Office
Office européen des brevets

(11) **EP 3 152 152 B1**

(12) **FASCICULE DE BREVET EUROPEEN**

(45) Date de publication et mention
de la délivrance du brevet:
**13.06.2018 Bulletin 2018/24**

(51) Int Cl.:
***B81C 1/00*** *(2006.01)*          ***B82Y 30/00*** *(2011.01)*
***G03G 15/22*** *(2006.01)*        ***G03G 17/00*** *(2006.01)*

(21) Numéro de dépôt: **15732424.5**

(22) Date de dépôt: **03.06.2015**

(86) Numéro de dépôt international:
**PCT/IB2015/054195**

(87) Numéro de publication internationale:
**WO 2015/186074 (10.12.2015 Gazette 2015/49)**

(54) **IMAGE MINIATURE DE DEMI-TEINTES FORMEE PAR UN ASSEMBLAGE DE NANO-PARTICULES COLLOÏDALES ET SON PROCEDE DE REALISATION**

MINIATUR-HALBTONBILD AUS EINER ANORDUNG VON KOLLOIDNANOPARTIKELN UND VERFAHREN ZU DESSEN HERSTELLUNG

MINIATURE HALFTONE IMAGE FORMED BY AN ASSEMBLY OF COLLOIDAL NANOPARTICLES AND METHOD FOR PRODUCING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.06.2014 FR 1455132**

(43) Date de publication de la demande:
**12.04.2017 Bulletin 2017/15**

(73) Titulaires:
• **Institut National des Sciences Appliquées de Toulouse**
**31077 Toulouse Cedex 4 (FR)**
• **Centre National de la Recherche Scientifique**
**75016 Paris (FR)**

(72) Inventeurs:
• **RESSIER, Laurence**
**F-31520 Ramonville Saint Agne (FR)**
• **MOUTET, Pierre**
**F-31000 Toulouse (FR)**

(74) Mandataire: **Gevers & Orès**
**41 avenue de Friedland**
**75008 Paris (FR)**

(56) Documents cités:
**WO-A1-2013/071960      WO-A2-98/41531**
**US-B1- 6 690 419**

• **PALLEAU E ET AL: "Quantification of the electrostatic forces involved in the directed assembly of colloidal nanoparticles by AFM nanoxerography;Quantification of the electrostatic forces involved in the directed assembly of colloidal nanoparticles by AFM nanoxerography", NANOTECHNOLOGY, IOP, BRISTOL, GB, vol. 22, no. 32, 19 juillet 2011 (2011-07-19), page 325603, XP020208816, ISSN: 0957-4484, DOI: 10.1088/0957-4484/22/32/325603**
• **CHAD R BARRY ET AL: "Printing nanoparticles from the liquid and gas phases using nanoxerography; Printing nanoparticles from the liquid and gas phases using nanoxerography", NANOTECHNOLOGY, IOP, BRISTOL, GB, vol. 14, no. 10, 27 août 2003 (2003-08-27) , pages 1-7, XP020067644, ISSN: 0957-4484, DOI: 10.1088/0957-4484/14/10/301**
• **TYLER BLUMENTHAL ET AL: "Paper;Patterned direct-write and screen-printing of NIR-to-visible upconverting inks for security applications;Patterned direct-write and screen-printing of NIR-to-visible upconverting inks for security applications", NANOTECHNOLOGY, IOP, BRISTOL, GB, vol. 23, no. 18, 13 avril 2012 (2012-04-13), page 185305, XP020222418, ISSN: 0957-4484, DOI: 10.1088/0957-4484/23/18/185305**

EP 3 152 152 B1

**Description**

La présente invention concerne des motifs micro-/ nanométriques ou images miniatures de demi-teintes formés par un assemblage de nanoparticules et un procédé de fabrication de tels motifs.

Les images de demi-teintes possèdent la remarquable capacité de traduire des contrastes de valeur ou clair-obscur en utilisant une base binaire, par exemple le blanc et le noir à partir de points fixes dénommés pixels de taille, forme et disposition relative variables.

De tels motifs demi-teintes peuvent être réalisés classiquement par des imprimantes à jet d'encre qui utilisent plusieurs gouttes d'encre de petite taille mélangées, déposées, et absorbées sur un même point d'impression d'un substrat support par des forces de capillarité.

Les meilleures performances en terme de résolution spatiale des points d'impression, connues à ce jour et obtenues pour des motifs de demi-teintes élaborés selon des procédés de type à jet d'encre ont été rapportées dans l'article l'article de W. Sele intitulé « Lithography-Free, Self-Aligned Inkjet Printing with Sub-Hundred-Nanometer Resolution », et publiées dans Advanced Materials, vol. 17, n° 8, pp. 997-1001, April 2005. Dans cet article, la technique d'impression de motifs demi-teintes utilisée, dans un cadre académique, présente des performances de résolution spatiale des points d'impression de 100 nm pour des motifs réalisés à géométrie spécifique, cette performance n'ayant pas été démontrée en général pour des motifs de forme quelconque.

Dans le domaine de la recherche, une autre technique que celle à jet d'encre dite de « nano-imprint », décrite dans l'article de T. Kraus et al., intitulé « Nanoparticle printing with single-particle résolution », publiée dans Nature Nanotechnology, vol.2, n°.9, pp.570-576, September 2007, est à remarquer, pour laquelle les performances de résolution spatiale des points d'impression sont de 60nm.

PALLEAU E ET AL: "Quantification of the electrostatic forces involved in the directed assembly of colloidal nanoparticles by AFM nanoxerography;Quantification of the electrostatic forces involved in the directed assembly of colloidal nanoparticles by AFM nanoxerography",NANOTECHNOLOGY, IOP, BRISTOL, GB, vol. 22, no. 32, 19 juillet 2011 (2011-07-19), page 325603, et XP020208816,ISSN: 0957-4484, DOI: 10.1088/0957-4484/22/32/325603, et CHAD R BARRY ET AL: "Printing nanoparticles from the liquid and gas phases using nanoxerography; Printing nanoparticles from the liquid and gas phases using nanoxerography",NANOTECHNOLOGY, IOP, BRISTOL, GB, vol. 14, no. 10, 1 octobre 2003 (2003-10-01), pages 1057-1063, XP020067644,ISSN: 0957-4484, DOI: 10.1088/0957-4484/14/10/301, décrivent des motifs de demi-teintes sur un substrat électret comprenant des points d'injection.

WO 2013/071960 A1 (SICPA HOLDING SA [CH]; DECOUX ERIC [CH]; VUISTINER DAVE [CH]) 23 mai 2013 (2013-05-23) décrit un procédé de marquage d'un motif de codage d'une information numérique sur une surface. Le problème technique est de fabriquer des motifs micro-/ nanométriques ou images miniatures de demi-teintes dans lesquels le nombre de demi-teintes (ou tonalité) maximal est important en regard de l'état de l'art et la résolution spatiale des points d'impression est minimale.

En particulier, on cherche à fabriquer des motifs micro-/ nanométriques pouvant atteindre plusieurs dizaines de milliers de demi-teintes sur un pixel de $1\mu m^2$, et dont la résolution spatiale maximale des points d'impression est de l'ordre de quelques nanomètres.

A cette fin, l'invention a pour objet procédé de fabrication d'un motif miniature de demi-teintes sur un substrat électret à partir d'une image de demi-teintes formée d'un agencement bimensionnel de pixels de demi-teintes compris dans un ensemble de demi-teintes allant du clair au sombre, caractérisé en ce qu'il comprend les étapes consistant à :

Générer électroniquement un fichier image de demi-teintes composés de pixels, chaque pixel étant défini par des coordonnées bidimensionnelles et une valeur codante de demi-teinte du pixel qui lui est associé,
Convertir le fichier image en un script d'injection, exécutable par un logiciel de commande d'un dispositif d'injection de charges électriques, le script d'injection permettant de reproduire l'image à une échelle réduite en faisant correspondre à chaque pixel un point d'injection de charges électriques sur une surface de réception plane du substrat électret située à un emplacement prédéterminé, le point d'injection étant caractérisé par une tension et un temps d'injection dépendant du niveau de demi-teintes du pixel correspondant selon une fonction monotone de conversion du niveau de demi-teinte en tension et temps d'injection, de sorte qu'une carte du potentiel de surface obtenue après injection des charges en les points d'injection reproduise à une échelle réduite l'image de demi-teintes,
Injecter sur la surface plane de réception du substrat électret des charges électriques par un procédé d'injection, adapté au dispositif d'injection et suivant le script d'injection obtenu dans l'étape précédente, ;
mettre en contact le substrat électret ayant la surface de réception inscrite par le potentiel de surface suivant le motif souhaité de charges électriques, avec une dispersion colloïdale pendant une durée de mise en contact suffisamment longue et inférieure ou égale à quinze minutes,
la dispersion colloïdale comportant des nanoparticules colloïdales neutres ou quasi-neutres électriquement et électriquement polarisables sous l'action d'un champ électrique externe ou des nanoparticules chargées, et un milieu de dispersion, sous la forme d'un solvant liquide ou d'un gaz, dans lequel les nanoparticules colloïdales sont dispersées.

Suivant des modes particuliers de réalisation, le procédé de fabrication d'un motif miniature de demi-teintes comporte l'une ou plusieurs des caractéristiques suivantes, prises seules ou en combinaison :

-   le pas d'injection défini comme la distance séparant deux points d'injection immédiatement voisins est choisie de sorte que la taille de l'image miniature est égale à la dimension de l'image exprimée en pixels moins un multipliée par le pas d'injection ;
-   de l'information est cachée au sein du motif par un procédé de cryptographie selon un algorithme prédéterminé ;
-   pour un type de nanoparticules donné, un type de solvant donné, une concentration de dispersion colloïdale fixée, les tensions d'injection sont modulées dans une plage de valeurs de tension d'injection à laquelle correspond de manière monotone une plage de valeurs de potentiels de surface modulants, la borne inférieure des valeurs absolues des tensions sur la plage de valeurs des tensions d'injection étant choisie pour que la borne inférieure correspondante des valeurs absolues des potentiels de surface de la plage de valeurs de potentiels de surface modulants soit supérieure ou égale à une première valeur seuil de potentiel de surface qui garantit lorsqu'elle est dépassée par des valeurs supérieures que l'assemblage élémentaire de nanoparticules sur le pixel est au minimum visible par microscopie optique en champ sombre tandis que lorsqu'elle n'est pas dépassée, l'assemblage élémentaire de nanoparticules sur le pixel reste invisible par microscopie optique en champ sombre ;
-   la borne supérieure des valeurs absolues des tensions sur la plage de valeurs des tensions d'injection est choisie pour que la borne supérieure correspondante des valeurs absolues des potentiels de surface de la plage de valeurs de potentiels de surface modulants soit inférieure ou égale à une deuxième valeur seuil de valeur absolue de potentiel de surface qui garantit lorsqu'elle n'est pas dépassée par des valeurs supérieures que l'assemblage élémentaire de nanoparticules sur le pixel réalisé est visible par microscopie optique en champ sombre et invisible en champ clair tandis que lorsqu'elle est dépassée par des valeurs supérieures l'asemblage élémentaire de nanoparticules sur le pixel est visible par microscopie optique en champ clair ;
-   la borne inférieure des valeurs absolues des tensions sur la plage de valeurs des tensions d'injection est choisie pour que la borne inférieure correspondante des valeurs absolues des potentiels de surface de la plage de valeurs de potentiels de surface modulants soit égale à la première valeur seuil de potentiel de surface qui garantit lorsqu'elle est dépassée que le motif miniature réalisé est visible par microscopie optique en champ sombre tandis que lorsqu'elle n'est pas dépassée par des valeurs supérieures le motif miniature reste invisible par microscopie optique en champ sombre, et

la borne supérieure des valeurs absolues des tensions sur la plage de valeurs des tensions d'injection est choisie pour que la borne supérieure correspondante des valeurs absolues des potentiels de surface de la plage de valeurs de potentiels de surface modulants soit égale à la deuxième valeur seuil de la valeur absolue de potentiel de surface qui garantit que lorsqu'elle n'est pas dépassée par des valeurs supéreures, le motif miniature réalisé est visible par microscopie optique en champ sombre et invisible en champ clair tandis que lorsqu'elle est dépassée par des valeurs supérieures le motif miniature est visible au moins partielellement par microscopie optique en champ clair ;

-   les nanoparticules colloïdales possèdent la propriété de convertir un rayonnement dans un spectre proche de l'infrarouge (NIR) en un rayonnement dans un premier spectre du visible ;
-   l'étape d'inscription du potentiel électrique de surface sur la surface de réception du substrat électret suivant un motif de charges est réalisé au choix,

par un procédé d'inscription séquentielle de charges positives et/ou négatives sur le substrat électret compris dans l'ensemble formé par une inscription de charges électriques par un faisceau d'ions focalisés, une inscription de charges électriques par un faisceau d'électrons focalisés, une inscription de charges électriques par microscopie à force atomique (AFM) et une inscription de charges électriques par électrophotographie,
par un procédé d'inscription en parallèle de charges positives et/ou négatives sur le substrat électret compris dans l'ensemble formé par la nano impression électrique et le microcontact électrique.

-   le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium ($Si_3N_4$), l'oxyde de silicium ($SiO_2$), le composé $Si_3N_4/SiO_2/Si$ (NOS) ;

les nanoparticules colloïdales sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nano particules colloïdales de base,

les nanoparticules colloïdales de base possédant un coeur solide et le cas échéant une coquille, et étant comprises dans l'ensemble formé par le latex, $SiO_2$, $TiO_2$, $ZrO_2$ ; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni ; Au, Ag, Cu, Pt, et les nanoparticules bi-métalliques ; $WO_3$ ; $NaLnF_4$, les fluorures de lanthanide ($LnF_3$), les oxydes de lanthanides ($Ln_2O_3$), les zirconates, silicates, hydroxydes ($Ln(OH)_3$) et les sulfures d'oxydes dopés ou non avec un ou plusieurs lanthanides différents (Ln désignant un lanthanide), les mélanges de ces composés,

et le milieu dispersant des nanoparticules polarisables est au choix un solvant liquide ou un gaz non polarisant,

le solvant liquide étant compris dans l'ensemble formé par le pentane, l'iso-pentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène, le gaz dispersant non polarisant étant compris dans l'ensemble formé par le diazote $N_2$, l'argon Ar, et l'air.

L'invention a également pour objet un motif miniature de demi-teintes sur un substrat électret correspondant à une image de demi-teintes formé par un agencement bimensionnel de pixels de demi-teintes compris dans un ensemble de demi-teintes allant du clair au sombre, comprenant

un substrat électret,

un ensemble de points d'injection disposés sur une surface libre du substrat électret,

chaque point d'injection du motif miniature étant défini par des coordonnées bidimensionnelles considérées sur la surface et un niveau de demi-teintes compris dans un ensemble de demi-teintes allant du clair au sombre, les coordonnées bidimensionnelles des points d'injection correspondant respectivement aux coordonnées des pixels de l'image, et les niveaux de demi-teintes des points d'injection correspondant respectivement aux niveaux de demi-teintes des pixels associés, de façon à reproduie l'image à une échelle réduite,

sur chaque point d'injection étant fixé un assemblage colloïdale élémentaire de nanoparticules colloïdales, neutres ou quasi-neutres électriquement et électriquement polarisables sous l'action d'un champ électrique externe, piégées sur le substrat au travers de forces diélectrophorétiques, ou un assemblage colloïdale élémentaire de nanoparticules colloïdales chargées piégées sur le substrat au travers de forces éectrophorétiques,

l'assemblage élémentaire ayant une forme et ou une densité caractérisant par ses propriétés optiques réfléchissantes ou émettrices un niveau de demi-teinte de manière unique et différente en étant conforme à la fonction de conversion, dans lequel le nombre de demi-teintes est supérieur ou égal à 10, de préférence supérieur ou égal à 20, et la résolution des points d'impression est inférieure ou égale à 30nm, de préférence inférieure ou égale à 20nm.

Suivant des modes particuliers de réalisation, le motif miniature de demi-teintes comporte l'une ou plusieurs des caractéristiques suivantes, prises seules ou en combinaison :

- lorsque les nanoparticules colloïdales sont neutres ou quasi-neutres électriquement et électriquement polarisables sous l'action d'un champ électrique externe, les assemblages élémentaires des nanoparticules colloïdales sont des assemblages compris dans l'ensemble formé par les assemblages monocouches compacts, les assemblages multicouches compacts, et les assemblages monocouches non compacts ;

- le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium ($Si_3N_4$), l'oxyde de silicium ($SiO_2$), le composé $Si_3N_4/SiO_2/Si$ (NOS) ;

les nanoparticules colloïdales sensiblement neutres et polarisables électriquement sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nanoparticules colloïdales de base,

les nanoparticules colloïdales de base possédant un coeur solide et le cas échéant une coquille, et étant comprises dans l'ensemble formé par le latex, $SiO_2$, $TiO_2$, $ZrO_2$ ; CdS, CdSe, PbSe, GaAs, GaN, InP, $In_2O_3$, ZnS, ZnO, $MoS_2$, Si, C, ITO ,$Fe_2O_3$, $Fe_3O_4$, Co, Fe-Co, $Fe_3C$, $Fe_5C_2$, Ni ; Au, Ag, Cu, Pt, et les nanoparticules bi-métalliques ; $WO_3$ ; $NaLnF_4$, les fluorures de lanthanide ($LnF_3$), les oxydes de lanthanides ($Ln_2O_3$), les zirconates, silicates, hydroxydes ($Ln(OH)_3$) et les sulfures d'oxydes dopés ou non avec un ou plusieurs lanthanides différents (Ln désignant un lanthanide), les mélanges de ces composés ;

- les nanoparticules possèdent la propriété de convertir un rayonnement dans un spectre proche de l'infrarouge (NIR) en un rayonnement dans un premier spectre du visible ;

- le motif miniature est configuré en termes de forme et densité pour être visible par microscopie optique en champ sombre et invisible par microscopie en champ clair.

L'invention a également pour objet une étiquette de marquage anti-contrefaçon et de traçabililité comprenant un motif miniature de demi-teintes sur un substrat électret défini ci-dessus par le procédé définie ci-dessus.

Le contrôle de la densité et de la forme d'assemblage de nanoparticules permet de reproduire dans toute sa richesse les nuances et contrastes d'une image de référence. Les nanoparticules peuvent en outre présenter des propriétes physiques spécifiques, par exemple des propriétés de photoluminescence, permettant d'apporter un moyen supplémentaire de dissimulation d'informations dans l'image demi-teinte.

L'invention sera mieux comprise à la lecture de la description de plusieurs formes de réalisation qui vont suivre, données uniquement à titre d'exemples et faites en se référant aux dessins dans lesquels :

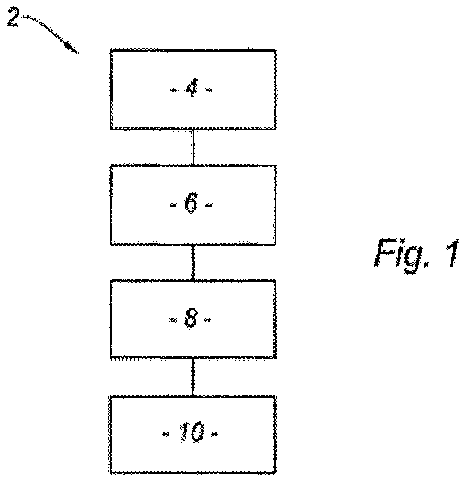

La Figure 1 est un ordinogramme général d'un procédé de fabrication d'un motif miniature de demi-teintes sur un substrat électret selon l'invention ;

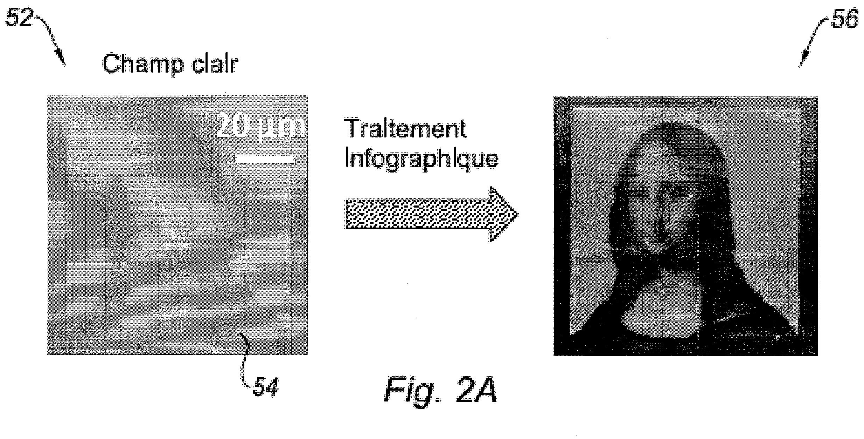

La Figure 2A est une image brute par microscopie optique en champ clair, suivie d'une image traitée correspondante, d'un motif de demi-teintes, réalisé par nanoxérographie de type Microscopie à Force Atomique (AFM) et à partir d'assemblages localisés de densités variables de nanoparticules $NaYF_4$ dopées avec des lanthanides, selon un premier script d'injection de charges et une première concentration de dispersion qui confèrent une visibilité en champ clair au motif;

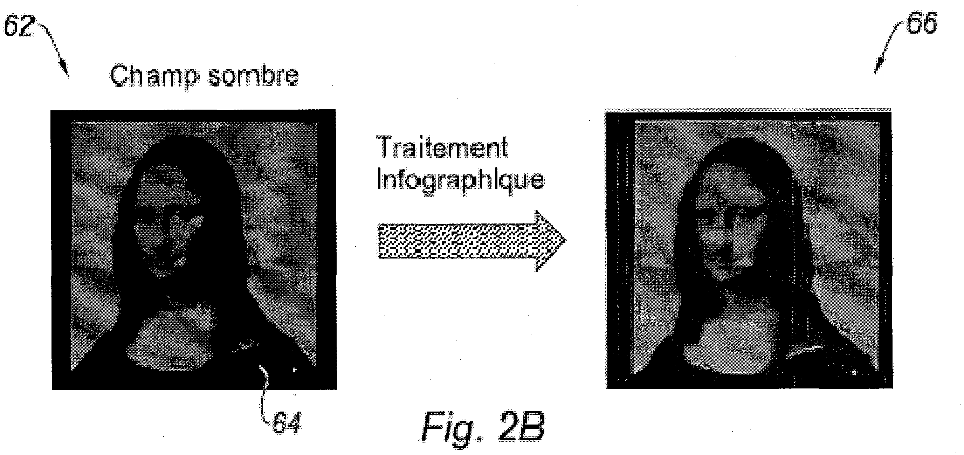

La Figure 2B est une image brute par microscopie optique en champ sombre suivie d'une image traitée correspondante, du même motif de la Figure 2A réalisé selon le même premier script d'injection de charges et la même concentration de dispersion colloïdale;

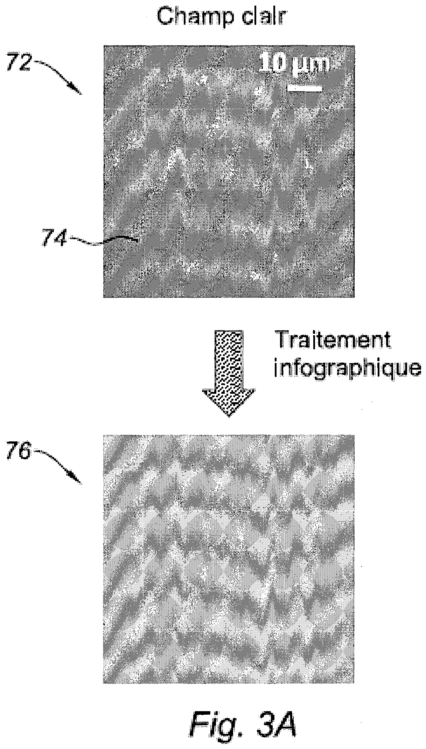

La Figure 3A est une image brute par microscopie optique en champ clair, suivie d'une image traitée correspondante, d'un motif de demi-teintes, réalisé par nanoxérographie de type AFM et à partir d'assemblages localisés de densités variables de nanoparticules $NaYF_4$ dopées avec des lanthanides, selon un deuxième script d'injection de charges et une deuxième concentration de dispersion qui confèrent une invisibilté en champ clair et une visibilité en champ sombre au motif ;

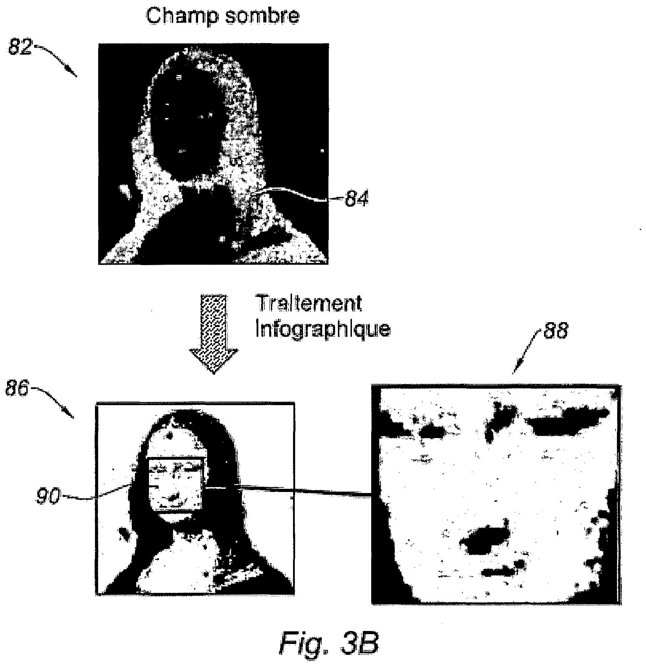

La Figure 3B est une une image brute par microscopie optique en champ sombre, suivie d'une image traitée correspondante et d'un détail agrandi de l'image traitée, du même motif de la Figure 3A réalisé selon le même deuxième script d'injection de charges et à la même deuxième concentration de dispersion que ceux de la Figure 3A ;

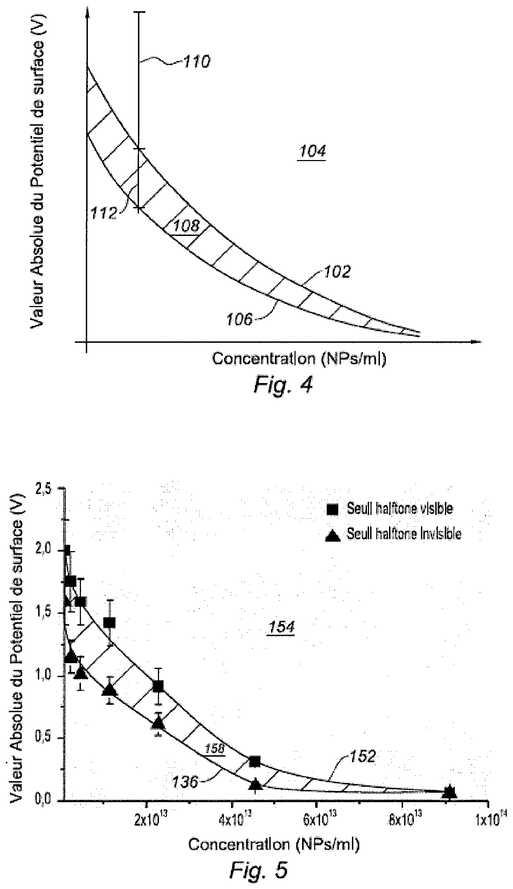

La Figure 4 est une vue d'une première courbe d'évolution d'un premier potentiel de surface seuil en fonction de la concentration de la dispersion colloïdale délimitant la frontière inférieure d'une première surface dans laquelle une gamme de variations du potentiel de surface du substrat électret associée à une concentration est contenue et permet de créer un assemblage de demi-tentes visibles par microscopie optique en champ clair et en champ sombre, et d'une deuxième courbe d'évolution d'un deuxième potentiel de surface seuil en fonction de la concentration de la dispersion colloïdale délimitant la frontière inférieure d'une deuxième surface, située en dessous de la première courbe, dans laquelle une gamme de variations du potentiel de surface du substrat électret associée à une concentration est contenue et permet de créer un assemblage de demi-tentes visibles par microscopie optique en champ sombre et invisibles en champ clair, dans le cas d'un dépôt de nanoparticules $NaYF_4$ dopées avec des lanthanides ;

La Figure 5 est une vue d'une troisième courbe d'évolution d'un premier potentiel de surface seuil en fonction de la concentration de la dispersion colloïdale délimitant la frontière inférieure d'une troisième zone surfacique dans laquelle des variations de potentiel de surface permettent de créer un assemblage de demi-tentes visibles par microscopie optique en champ clair et en champ sombre, et d'une quatrième courbe d'évolution d'un deuxième potentiel de surface seuil en fonction de la concentration de la dispersion colloïdale délimitant la frontière inférieure d'une quatrième zone, située en dessous de la première courbe, dans laquelle des variations de potentiel de surface permettent de créer un assemblage de demi-tentes visibles par microscopie optique en champ sombre et invisibles en champ clair, dans le cas d'un dépôt de nanoparticules d'argent ;

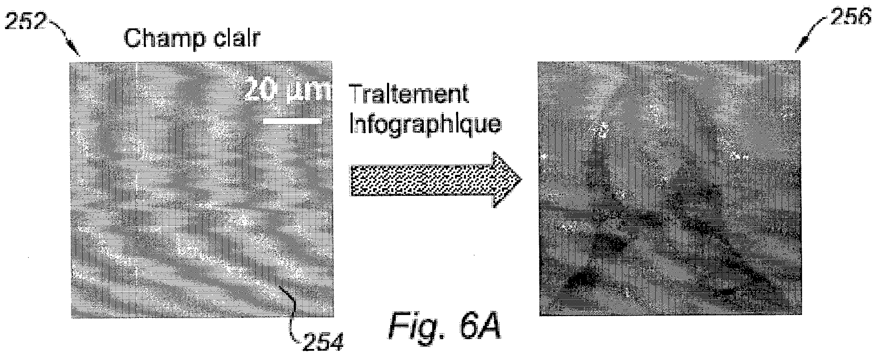

La Figure 6A est une image brute par microscopie optique en champ clair, suivie d'une image traitée correspondante, d'un motif de demi-teintes, réalisé par nanoxérographie de type AFM à partir d'assemblages localisés de densités variables de nanoparticules d'argent, selon un troisième script d'injection de charges et une troisième concentration de dispersion qui confèrent une visibilité en champ clair au motif;

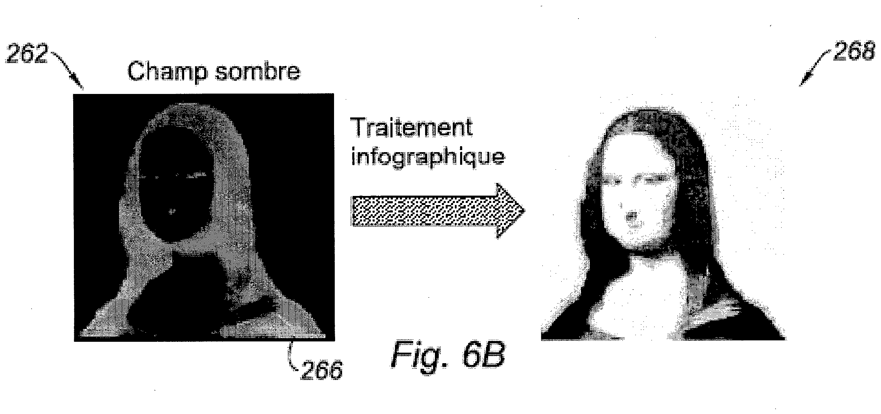

La Figure 6B est une image brute par microscopie optique en champ sombre suivie d'une image traitée correspondante du même motif de la Figure 6A réalisée selon le troisième script d'injection de charges et la troisième concentration de dispersion colloïdale identiques à ceux de la Figure 6A ;

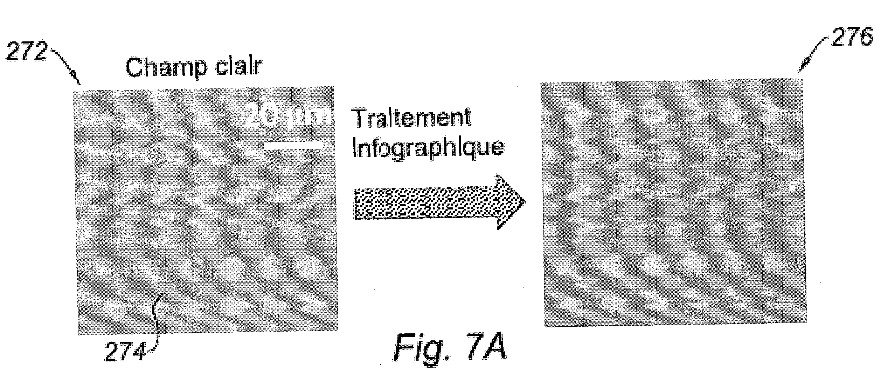

La Figure 7A est une image brute par microscopie optique en champ clair, suivie d'une image traitée correspondante, d'un motif de demi-teintes, réalisé par nanoxérographie de type AFM et à partir d'assemblages localisés de densités variables de nanoparticules d'argent, selon un quatrième script d'injection de charges et une quatrième concentration de dispersion colloïdale qui confèrent une invisibilité en champ clair et une visibilité en champ sombre au motif ;

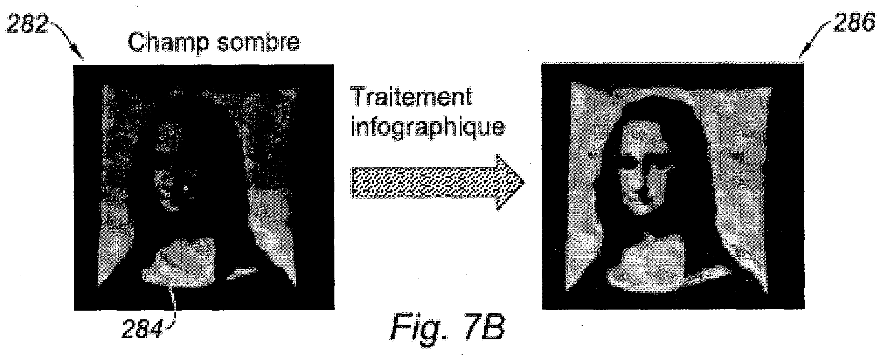

La Figure 7B est une image brute par microscopie optique en champ sombre, suivie d'une image traitée correspondante, du même motif de la Figure 7A réalisé selon le même quatrième script d'injection de charges et à la même quatrième concentration de dispersion colloïdale que ceux de la Figure 7A.

Suivant la Figure 1, un procédé 2 de fabrication d'un motif miniature de demi-teintes sur un substrat électret comprend en général un ensemble d'étapes exécutées successivement.

Dans une première étape 4, un fichier image de demi-teintes est générée électroniquement sous la forme d'un fichier informatique. L'image de demi-teintes est formé par un réseau de pixels de demi-teintes possédant des caractéristiques de demi-teintes allant du clair au sombre. Chaque pixel est défini électroniquement a minima par des coordonnées bidimensionnelles et une valeur codante de demi-teinte associée. Pour la mise en oeuvre de la première étape 4, un format informatique d'image Noir et Blanc est choisi dans l'ensemble des formats d'image formé par BMP, GIF, JPEG, LBM, PCX, PNG, PNM, TGA, TIFF, WEBBP, XCF, XPM, XV.

Dans une deuxième étape 6, le fichier image de pixels est converti en un script d'injection, exécutable par un logiciel de commande d'un dispositif d'injection de charges électriques. Le script d'injection est configuré pour reproduire l'image à une échelle réduite sur une surface de réception plane du substrat électret, prévue pour recevoir le motif miniature et située à un emplacement prédéterminée, en faisant correspondre à chaque pixel un point d'injection de charges sur la surface de réception, les charges pouvant être des charges électriques ou des charges de polarisation. Le point d'injection est caractérisé par une tension et un temps d'injection qui dépendent du niveau de demi-teintes du pixel correspondant selon une fonction à variation monotone de conversion de niveau de demi-teinte en tension d'injection, de sorte que la carte du potentiel de surface qui sera obtenue après injection des charges sur la surface de réception du substrat électret en les points d'injection reproduira à une échelle réduite l'image.

Pour la mise en oeuvre de la deuxième étape 6, un pas d'injection, défini comme la distance séparant centre à centre de deux points d'injection immédiatement voisins, est choisi de sorte que la taille de l'image miniature désirée est égale à la dimension de l'image exprimée en pixels moins un multipliée par le pas d'injection.

Dans une troisième étape 8, des charges sont injectées sur et dans le substrat électret au niveau de la zone de surface par un procédé classique d'injection suivant le script d'injection obtenu dans la deuxième étape 6.

Le procédé classique d'injection des charges est par exemple celui décrit dans la demande de brevet français intitulée « Micro/nano structures de nanoparticules colloïdales fixées sur un substrat électret et procédé de fabrication de telles micro/nano structures » déposé le 8 mars 2013 et ayant le numéro de dépôt FR 13 52092.

La troisième étape 8 d'inscription du potentiel électrique de surface sur la surface de réception du substrat électret suivant le motif de charges du script est réalisé au choix :

- par un procédé d'inscription séquentielle de charges positives et/ou négatives sur le substrat électret compris dans l'ensemble formé par une inscription de charges électriques par un faisceau d'ions focalisés, une inscription de charges électriques par un faisceau d'électrons focalisés, une inscription de charges électriques par microscopie à force atomique (AFM) et une inscription de charges électriques par électrophotographie, ou
- par un procédé d'inscription en parallèle de charges positives et/ou négatives sur le substrat électret compris dans l'ensemble formé par la nano impression électrique et le microcontact printing électrique.

Puis dans une quatrième étape 10, le substrat électret ayant la surface de réception inscrite par le potentiel de surface suivant le motif souhaité de charges électriques, est mis en contact avec une dispersion colloïdale pendant une durée de mise en contact suffisamment longue et inférieure ou égale à quinze minutes. Typiquement, les durées de mise en contact sont comprises entre 30 secondes et quelques minutes.

La dispersion colloïdale comporte ici des nanoparticules colloïdales neutres ou quasi-neutres électriquement et électriquement polarisables sous l'action d'un champ électrique externe, et un milieu de dispersion, sous la forme d'un solvant liquide ou d'un gaz, sensiblement dépourvu d'action de polarisation électrique, dans lequel les nanoparticules colloïdales sont dispersées.

En variante, les nanoparticules colloïdales sont électriquement chargées.

De manière générale, le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium ($Si_3N_4$), l'oxyde de silicium ($SiO_2$), le composé $Si_3N_4/SiO_2/Si$ (NOS).

De manière générale, les nanoparticules colloïdales sensiblement neutres et polarisables électriquement ou les nanoparticules colloïdales électriquement chargées sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nano particules colloïdales de base,

Les nanoparticules colloïdales de base possèdent un coeur solide et le cas échéant une coquille, et sont comprises dans l'ensemble formé par le latex, $SiO_2$, $TiO_2$, $ZrO_2$ ; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni ; Au, Ag, Cu, Pt, et les nanoparticules bi-métalliques ; $WO_3$ ; $NaLnF_4$, les fluorures de lanthanide ($LnF_3$), les oxydes de lanthanides ($Ln_2O_3$), les zirconates, silicates, hydroxydes ($Ln(OH)_3$) et les sulfures d'oxydes dopés ou non avec un ou plusieurs lanthanides différents (Ln désignant un lanthanide), les mélanges de ces composés.

Lorsque le milieu dispersant des nanoparticules polarisables est un solvant liquide non polarisant, le solvant est compris dans l'ensemble formé par le pentane, l'iso-pentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène.

Lorsque le milieu dispersant est un gaz dispersant non polarisant, le gaz dispersant est compris dans l'ensemble formé par le diazote $N_2$, l'argon Ar, et l'air.

De manière avantageuse, et en tant que premier niveau de dissimulation d'informations, la petite taille du motif de demi-teintes obtenue par le procédé général de la Figure 1 rend la localisation du motif complexe sur de grandes surfaces d'électret dépourvues de repérage.

Il est à remarquer qu'il est possible de cacher de l'information au sein du motif obtenu par un procédé de cryptographie selon un algorithme prédéterminé, ce qui constitue un deuxième niveau de dissimulation d'informations. Par exemple, une deuxième image non visible avant décodage est encodée dans une première image, visible directement sans traitement d'image.

Suivant un premier mode de réalisation du procédé général de la Figure 1, les nanoparticules colloïdales possèdent la propriété de convertir un rayonnement dans un spectre proche de l'infrarouge (NIR) en un rayonnement dans un premier spectre du visible.

Par exemple, les nanoparticules sont des nanoparticules de $NaYF_4$ dopées avec des lanthanides.

Ces nanoparticules sont des nanoparticules polarisables et non chargées de 28 nm de diamètre, enrobées d'acide oléique, dopées en Erbium et Ytterbium, luminescentes, dispersées dans de l'hexane à une première concentration colloîdale C1 de $1,49*10^{13}$ Nano Particules (NPs)/ml (ce qui corresepond 0,12mg.ml$^{-1}$).

Il est à noter que ces particules aboutissent ici de manière particulière à un assemblage systématiquement compact et parfois multicouches. L'effet final de demi-teintes (en anglais halftone) sera créé par variation de la surface et/ou de l'épaisseur d'assemblage des nanoparticules sur chacun des sites correspondants aux points d'injection sur le substrat électret.

En variante, l'assemblage peut ne pas être compact. Dans ce cas, l'effet final de demi-tente sera créé par la variation de la densité de surface projetée et de la forme de l'assemblage des nanoparticules sur chacun des sites correspondants aux points d'injection sur le substrat électret, la densité de surface projetée étant égale au nombre de particules contenues dans le cylindre délimité par une unité de surface. Lorsque l'assemblage est monocouche, la notion de densité de surface projetée se confond avec la notion de densité surfacique classique de nanoparticules. Ainsi, l'effet de demi-teinte final peut être un effet de variation de densité sans nécessairement présence de compacité des nanoparticules dans l'assemblage.

Suivant un premier script d'injection, les tensions appliquées entre la pointe AFM et le substrat électret varient de +50 V, valeur correspondant à un pixel blanc, à +75 V, valeur correspondant à un pixel noir.

Les potentiels de surfaces des points d'injection varient de manière correspondante d'un premier potentiel de surface inférieur $V_{kfm1min}$ +130 mV à un premier potentiel de surface supérieur $V_{kfm1max}$ + 950 mV.

Après injection des charges, le substrat électret injecté est immergé durant 30 secondes dans un bain de nanoparticules $NaYF_4$ colloïdales de la première concentration C1 de $1,49*10^{13}$ Nano Particules (NPs)/ml (c'est-à-dire de 0.12 mg/ml). Ensuite, après le retrait de la dispersion, le substrat est séché par évaporation du solvant à température ambiante. Dans ces conditions, l'assemblage final des nanoparticules sur un point d'injection lorqu'il a lieu est compact, pouvant être multicouches ou monocouche.

Dans ce cas, le motif de demi-teintes obtenu est visible en champ clair comme illustré sur la Figure 2A qui représente à gauche une première vue brute 52, c'est-à-dire sans traitement d'image, de la Joconde 54 formant le motif, et à droite une deuxième vue 56, améliorée en terme de filtrage du bruit par un traitement infographique.

Dans ce cas, le motif de demi-teintes obtenu est également visible en champ sombre comme illustré sur la Figure 2B qui représente à gauche une première vue brute 62 en champ sombre de la même Joconde 64, de meilleure qualité que la première vue brute 52 en champ clair, et à droite une deuxième vue améliorée 66 de la première vue brute 62 en champ sombre par un traitement infographique.

Suivant un deuxième mode de réalisation du procédé général de la Figure 1, dérivé du premier mode de réalisation, les mêmes nanoparticules de $NaYF_4$ colloïdales sont utilisées dans une même dispersion d'hexane à une deuxième concentration colloïdale C2, ici identique à la première concentration C1 de la dispersion colloîdale, c'est à dire égale à $1,49*10^{13}$ Nano Particules (NPs)/ml (ou 0.12 mg/ml).

Le deuxième mode de réalisation diffère du premier mode de réalisation par un deuxième script d'injection dans lequel les tensions d'injection appliquées entre la pointe AFM et le substrat électret varient de +40 V à +50 V. Les potentiels de surface des points d'injection varient de manière correspondante d'un deuxième potentiel de surface inférieur $V_{kfm2min}$ +30 mV à un deuxième potentiel de surface supérieur $V_{kfm2max}$ +130 mV.

Après injection, le substrat électret est immergé durant 30 secondes dans un bain de $NaYF_4$ colloïdales de deuxième concentration colloïdale égale à $1,49*10^{13}$ nanoparticules (NPs)/ml. Après retrait de la dispersion, le substrat est séché par évaporation du solvant à température ambiante.

En variante, le motif de demi-teintes obtenu par la mise en oeuvre selon le deuxième mode de réalisation peut également être obtenu en utilisant un script d'injection identique au premier script d'injection (c'est-à-dire un potentiel de surface variant de +130 mV à un potentiel de surface + 950 mV), et en ajustant la concentration de la dispersion colloïdale à une valeur adaptée, inférieure à la deuxième concentration C2 de dispersion colloïdale, et égale à $1,86*10^{11}$ nanoparticules (NPs)/ml (ou 1.5 $\mu$g/ml).

Au cours de cette variante, après injection, le substrat est immergé durant 30 secondes dans un bain de nanoparticules de $NaYF_4$ colloïdales de concentration $1,86*10^{11}$ nanoparticules (NPs)/ml. Après retrait de la dispersion, le substrat est séché par évaporation du solvant à température ambiante.

Dans tous les cas correspondant au deuxième mode de réalisation, la variante comprise, l'assemblage final des nanoparticules sur chaque point d'injection lorsqu'il a lieu est compact, pouvant être multicouches ou monocouche.

Dans le cas du deuxième mode de réalisation, le motif de demi-teintes obtenu est invisible en champ clair comme en atteste la Figure 3A pour laquelle une première vue brute 72, c'est-à-dire sans traitement d'image, ne fait apparaitre qu'un fond monotone bruité 74 sans Joconde, et en dessous une deuxième vue 76 censée améliorée en terme de filtrage du bruit par un traitement infographique pour faire apparaître un motif demi-teintes souhaité, ne fait apparaître qu'un fond monotone sans motif observable.

En revanche, dans le cas du deuxième mode de réalisation, le motif de demi-teintes obtenu est visible en microscopie optique en champ sombre comme illustré sur la Figure 3B qui représente en haut une première vue brute 82 en champ sombre de la Joconde 84 déjà visible, une deuxième vue améliorée 86, obtenue à partir la première vue brute 82 en champ sombre par un traitement infographique et à la même échelle, ainsi qu'une troisième vue 88 d'un détail agrandie 90 de la deuxième vue améliorée 86. Les deuxième et troisième vues 86, 88 mettent en évidence la qualité de la finesse des contrastes des demi-teintes reproduites du motif reproduit à une échelle réduite.

Suivant la Figure 4, une première courbe 102 réprésente l'évolution de la valeur absolue |Vs1| d'un premier potentiel de surface seuil Vs1 en fonction de la concentration de la dispersion colloïdale Cs1 lorsque la dispersion colloïdale est une dispersion colloïdale de nanoparticules, identiques à celles des premier et deuxième modes de réalisation, et diluées dans de l'hexane.

La première courbe 102 délimite une première zone 104, définie par les couples de points (C1, |Vkfm1|) constitués chacun d'une première concentration colloïdale C1 et de la valeur absolue d'un premier potentiel de surface |Vkfm1|, qui vérifient l'inégalité suivante :

$$|Vkfm1| \geq f1(C1) \qquad (\text{relation (1)})$$

f1 désignant la fonction décrivant la première courbe 102 comme ensemble des points ayant pour coordonnées (Cs1, Vs1) et vérifiant l'égalité f1(Cs1)= Vs1.

Les points de la première zone 104 définissent le domaine de variation des paramètres de fabrication d'un assemblage miniature colloïdale en termes de valeurs absolues de potentiels de surface et de concentration de la dispersion colloïdale qui sont nécessaires et suffisants pour que l'assemblage soit un assemblage miniature de demi-teintes visibles en champ clair.

Une deuxième courbe d'évolution 106 représente l'évolution de la valeur absolue |Vs2| d'un deuxième potentiel de surface seuil en fonction de la concentration de la dispersion colloïdale Cs2 lorsque la dispersion colloïdale est une dispersion colloïdale de nanoparticules, identiques à celles des premier et deuxième modes de réalisation, et diluées dans de l'hexane.

Une deuxième courbe 106 délimite une deuxième zone 108 définie par les couples de points (C2, |Vkfm2|) constitués chacun d'une deuxième concentration colloïdale C2 et de la valeur absolue d'un deuxième potentiel de surface |Vkfm2|, qui vérifient la double inégalité suivante :

$$f1(C2) \geq |Vkfm2| \geq f2(C2) \qquad (\text{relation (2)})$$

f2 désignant la fonction décrivant la deuxième courbe 106 comme ensemble des points ayant pour coordonnées (Cs2, Vs2) vérifiant l'égalité f2(Cs2)= Vs2.

Les points de la deuxième zone 108 définissent le domaine de variation des paramètres de fabrication d'un assemblage miniature colloïdale en termes de valeurs absolues de potentiels de surface et de concentrations de la dispersion colloïdale qui sont nécessaires et suffisants pour que l'assemblage soit un assemblage miniature en demi-teintes visibles en champ sombre et invisibles en champ clair.

Sur la Figure 4 est représentée la plage de variation des potentiels de surface du premier mode de réalisation à la première concentration colloïdale C1 de $1,49*10^{13}$ nanoparticules (NPs)/ml au travers d'un premier segment 110 dont les ordonnées sur l'axe des valeurs absolues des potentiels de surface varient le long de l'axe depuis la valeur $|V_{kfm1min}|$ égale à +130 mV jusqu'à la borne $|V_{kfm1max}|$, égale à +950 mV et non représentée sur la Figure 4.

La plage de variation des valeurs absolues des potentiels de surface du deuxième mode de réalisation à la deuxième concentration colloïdale C2 de $1,49*10^{13}$ Nano Particules (NPs)/ml est représentée au travers d'un deuxième segment 112 dont les ordonnées sur l'axe du potentiel de surface varient entre $|V_{kfm2min}|$ égal à +30 mV et $|V_{kfm2max}|$ égal à +130mV.

Suivant la Figure 5, une troisième courbe 152 réprésente l'évolution de la valeur absolue $|Vs3|$ d'un troisième potentiel de surface seuil Vs3 en fonction de la concentration seuil de la dispersion colloïdale Cs3 lorsque la dispersion colloïdale est une dispersion colloïdale de nanoparticules, identiques à celles du troisième mode de réalisation et du quatrième mode de réalisation en termes de type de nanoparticules et de type de solvant.

Dans les troisième et quatrième modes de réalisation, les nanoparticules colloïdales utilisées sont des particules d'argent d'une dispersion commerciale. Les particules d'argent ont un diamètre compris entre 5 et 15 nm, et sont enrobées de dodecanethiol, non chargées, et dispersées dans de i'hexane selon une concentration intiale $9,09*10^{13}$ NPs/ml (c'est-à-dire 0,5mg.ml$^{-1}$).

Il est à noter que ces particules aboutissent à un assemblage non-compact, et en aucun cas multicouches. L'effet demi-teinte final sera créé par la variation de la densité et de la forme d'assemblage des nanoparticules sur les sites correspondant aux points d'injection. Il est rappelé ici que la variation de la densité d'assemblage des nanoparticules sur les sites correspondant aux points d'injection est une variation de densité projetée dans le cas d'un assemblage multicouches et une variation de densité surfacique classique dans le cas d'un assemblage monocouche.

La troisième courbe 152 délimite une troisième zone 154, définie par les couples de points (C3, $|Vkfm3|$) constitués chacun d'une troisième concentration colloïdale C3 et de la valeur absolue d'un troisième potentiel de surface $|Vkfm3|$, qui vérifient l'inégalité suivante :

$$|Vkfm3| \geq f3(C3) \qquad \text{(relation (3))}$$

f3 désignant la fonction décrivant la première courbe 152 comme ensemble des points ayant pour coordonnées (Cs3, Vs3) vérifiant l'égalité f1(Cs3)= Vs3.

Les points de la première zone 154 définissent le domaine de variation des paramètres de fabrication d'un assemblage miniature colloïdal en termes de valeurs absolues de potentiels de surface et de concentrations de la dispersion colloïdale qui sont nécessaires et suffisants pour que l'assemblage soit un assemblage miniature de demi-teintes visibles en champ clair seulement.

Une quatrième courbe d'évolution 156 représente l'évolution la valeur absolue $|Vs4|$ d'un quatrième potentiel de surface seuil en fonction de la concentration de la dispersion colloïdale Cs4 lorsque la dispersion colloïdale est une dispersion colloïdale de nanoparticules, identiques à celles des troisième et quatrième modes de réalisation.

La quatrième courbe 156 délimite une quatrième zone 158 définie par les couples de points (C4, $|Vkfm4|$) constitués chacun d'une quatrième concentration colloïdale C4 et de la valeur absolue d'un quatrième potentiel de surface $|Vkfm4|$, qui vérifient l'inégalité suivante :

$$f3(C4) \geq |Vkfm4| \geq f4(C4) \qquad \text{(relation (4))}$$

f4 désignant la fonction décrivant la quatrième courbe 156 comme ensemble des points ayant pour coordonnées (Cs4, Vs4) vérifiant l'égalité f4(Cs4)= Vs4.

Les points de la quatrième zone 158 définissent le domaine de variation des paramètres de fabrication d'un assemblage miniature colloïdal en termes de valeurs de absolues de potentiels de surface et de concentration de la dispersion colloïdale qui sont nécessaires et suffisants pour que l'assemblage soit un assemblage miniature en demi-teintes visibles en champ sombre et invisibles en champ clair.

Sur la Figure 5 est représentée la plage de variation des valeurs absolues des potentiels de surface du troisième mode de réalisation à une troisième concentration colloïdale C3 de 9,09*10^13 nanoparticules (NPs)/ml au travers d'un troisième segment 160 dont les ordonnées sur l'axe des valeurs absolues des potentiels de surface varient depuis la valeur $|V_{kfm3min}|$, égale à +140 mV, jusqu'à la valeur $|V_{kfm3max}|$, égal à +1,125V.

La plage de variation des valeurs absolues des potentiels de surface du quatrième mode de réalisation à la quatrième concentration colloïdale C4, ici égale à la troisième concentration colloïdale C3, c'est-à-dire 9,09*10^13 Nano Particules (NPs)/ml, est représentée au travers d'un quatrième segment 162 dont les ordonnées sur l'axe des valeurs abosolues des potentiels de surface varient entre +30 mV et +140 mV.

Suivant le troisième mode de réalisation du procédé général de la Figure 1, les tensions appliquées entre la pointe AFM et le substrat électret varient de -30 V, valeur correspondant à un pixel blanc, à -75 V, valeur correspondant à un pixel noir.

Les potentiels de surfaces des points d'injection varient de manière correspondante d'un troisième potentiel de surface inférieur $V_{kfm3min}$ égal à - 140 mV à un troisième potentiel de surface supérieur $V_{kfm3max}$ -1,125 V.

Après injection des charges, le substrat électret injecté est immergé durant 30 secondes dans un bain de particules d'argent colloïdales de concentration 9,09*10^13 nanoparticules (NPs)/ml (c'est-à-dire 0.5 mg/ml avant filtration). Ensuite, après le retrait de la dispersion, le substrat est séché par évaporation du solvant à température ambiante.

Dans ce cas, le motif de demi-teintes obtenu est visible en champ clair comme illustré sur la Figure 6A qui représente à gauche une première vue brute 252, c'est-à-dire sans traitement d'image, de la Joconde 254 formant le motif, et à droite une deuxième vue 256, améliorée en terme de filtrage du bruit par un traitement infographique.

Dans ce cas, le motif de demi-teintes obtenu est également visible en champ sombre comme illustré sur la Figure 6B qui représente à gauche une première vue brute 262 en champ sombre de la même Joconde 266, de meilleure qualité en terme de richesse informationnelle que la première vue brute 252 en champ clair, et à droite une deuxième vue améliorée 268 de la première vue brute 262 en champ sombre par un traitement infographique.

Suivant le quatrième mode de réalisation du procédé général de la Figure 1, dérivé du troisième mode de réalisation, les mêmes particules d'argent colloïdales sont utilisées dans une même dispersion d'hexane à une quatrième concentration colloïdale C4, ici identique à la troisième concentration de la dispersion colloïdale, c'est à dire égale à 9,09*10^13 nanoparticules (NPs)/ml.

Le quatrième mode de réalisation diffère du troisième mode de réalisation par un quatrième script d'injection dans lequel les tensions d'injection appliquées entre la pointe AFM et le substrat électret varient de - 20V à -30V. Les potentiels de surface des points d'injection varient de manière correspondante d'un quatrième potentiel de surface inférieur $V_{kfm4min}$ -30mV à un quatrième -140mV. Après injection, le substrat électret est immergé durant 30 secondes dans un bain de particules d'argent colloïdales de quatrième concentration de dispersion colloïdales égale à 9,09*10^13 nanoparticules (NPs)/ml. Après retrait de la dispersion, le substrat est séché par évaporation du solvant à température ambiante.

En variante, le motif de demi-teintes obtenu par la mise en oeuvre du quatrième mode de réalisation peut être obtenu en utilisant un script d'injection pour lequel le potentiel de surface varie de -900mV à -1,42 V, et en ajustant la concentration de la dispersion colloïdale à une valeur adaptée inférieure à la troisième concentration C3 de dispersion colloidale, et égale à 9,09*10^12 NPs/ml (ou 0.05 mg.ml^{-1} avant filtration).

Au cours de cette variante, après injection le substrat est immergé durant 30 secondes dans un bain de particules d'argent colloïdales de concentration 9,09*10^12 NPs/ml. Après retrait de la dispersion, le substrat est séché par évaporation du solvant à température ambiante.

Dans tous les cas correspondant au quatrième mode de réalisation, la variante comprise, l'assemblage final des nanoparticules sur chaque point d'injection lorqu'il a lieu n'est pas compact.

Dans le cas du quatrième mode de réalisation, le motif de demi-teintes obtenu est invisible en champ clair comme en atteste la Figure 7A pour laquelle une première vue brute 272, c'est-à-dire sans traitement d'image, ne fait apparaitre qu'un fond monotone bruité 274 sans Joconde, et à droite une deuxième vue 276, censée améliorée en terme de filtrage du bruit par un traitement infographique pour faire apparaître un motif demi-teintes souhaité, ne fait apparaître qu'un fond monotone sans motif structuré.

En revanche, dans ce cas du quatrième mode de réalisation, le motif de demi-teintes obtenu est visible en champ sombre comme illustré sur la Figure 7B qui représente à gauche une première vue brute 282 en champ sombre de la Joconde 284 déjà visible, et une deuxième vue améliorée 286, obtenue à partir de la première vue brute 282 en champ sombre après un traitement infographique. La deuxième vue 286 met en évidence la qualité de la finesse des contrastes des demi-teintes reproduites du motif reproduit à une échelle réduite.

De manière générale et pratique, pour un type de nanoparticules donné, un type de solvant donné et une concentration de dispersion colloïdale fixée, les tensions d'injection sont modulées dans une plage de valeurs de tension d'injection à laquelle correspond de manière monotone une plage de valeurs de potentiels de surface modulants, la borne inférieure des valeurs absolues des tensions sur la plage de valeurs des tensions d'injection étant choisie pour que la borne inférieure correspondante des valeurs absolues des potentiels de surface de la plage de valeurs de potentiels de surface modulants soit supérieure ou égale à une première valeur seuil de potentiel de surface qui garantit lorsqu'elle est dépassée que l'assemblage élémentaire de nanoparticules sur le pixel est au minimum visible par microscopie optique en champ sombre tandis que lorsqu'elle n'est pas dépassée, l'assemblage élémentaire de nanoparticules sur le pixel reste invisible par microscopie optique à champ sombre.

Cela permet d'obtenir un motif, riche en demi-teintes et ayant une résolution spatiale élevée, et visible en totalité au moins par microscopie optique en champ sombre.

De manière particulière, la borne supérieure des valeurs absolues des tensions sur la plage de valeurs des tensions d'injection est choisie pour que la borne supérieure correspondante des valeurs absolues des potentiels de surface de la plage de valeurs de potentiels de surface modulants soit inférieure ou égale à une deuxième valeur seuil de valeur absolue de potentiel de surface qui garantit lorsqu'elle n'est pas dépassée par la valeur absolue supérieure que l'assemblage élémentaire de nanoparticules sur le pixel est visible par microscopie optique en champ sombre et invisible en champ clair tandis que lorsqu'elle est dépassée par des valeurs supérieures l'assemblage élémentaire de nanoparticules sur le pixel est visible par microscopie optique en champ clair.

Cela permet d'obtenir un motif riche en demi-teintes et ayant une résolution spatiale élevée, invisible en totalité par microscopie optique en champ clair et visible en totalité par microscopie optique en champ sombre, c'est-à-dire un motif détectable et dissimulable à un certain degré. Ainsi, ce motif peut être utilisé comme une étiquette d'identification avec un degré de sécurité.

De manière plus particulière, la borne inférieure des valeurs absolues des tensions sur la plage de valeurs des tensions d'injection est choisie pour que la borne inférieure correspondante des valeurs absolues des potentiels de surface de la plage de valeurs de potentiels de surface modulants soit égale à la première valeur seuil de potentiel de surface qui garantit lorsqu'elle est dépassée par des valeurs supérieures que le motif miniature réalisé est au minimum visible par microscopie optique en champ sombre tandis que lorsqu'elle n'est pas dépassée l'assemblage élémentaire de nanoparticules sur le pixel reste invisible par microscopie optique à champ sombre. En même temps, la borne supérieure des valeurs absolues des tensions sur la plage de valeurs des tensions d'injection est choisie pour que la borne supérieure correspondante des valeurs absolues des potentiels de surface de la plage de valeurs de potentiels de surface modulants soit égale à la deuxième valeur seuil de valeur absolue des potentiels de surface qui garantit lorsqu'elle n'est pas dépassée par des valeurs supérieures que l'assemblage élémentaire de nanoparticules sur le pixel est visible par microscopie optique en champ sombre et invisible en champ clair tandis que lorsqu'elle est dépassée par des valeurs supérieures que l'assemblage élémentaire de nanoparticules sur le pixel est visible par microscopie optique en champ clair.

Cela permet d'obtenir un motif invisible en totalité par microscopie optique en champ clair et visible en totalité par microscopie optique en champ sombre dont la richesse en demi-teintes a été maximisée sur les plages de tensions possibles pour une concentration de la dispersion colloïdale fixée.

Les réalisations d'images demi-teintes par assemblages de nanoparticules telles que décrites ci-dessus permettent ainsi d'obtenir différents niveaux de dissimulation d'informations.

A un premier niveau, lorsque le motif de demi-tentes est de petite taille, cela rend sa localisation complexe sur de grandes surfaces dépourvues de repérages.

A un deuxième niveau, de l'information peut être cachée au sein du motif par un procédé de cryptographie selon un algorithme prédéterminé.

A un troisième niveau, dans le cas d'images de demi-teintes réalisées avec de faibles densités de nano-particuies, l'image finale est invisible par microscopie optique en champ clair et la visualisation de ces images nécessite a minima une observation par microscopie optique en champ sombre.

Un quatrième niveau concerne i'authentification du motif de demi-teintes dans le cas d'une image de demi-teintes réalisée avec des nanoparticules présentant une propriété physique spécifique comme par exemple des propriétés de luminescence. Il est possible de procéder alors à une authentification de l'image par vérification de cette propriété.

Ces différents niveaux de dissimulation d'information peuvent être combinés sans restriction.


## Revendications

**1.** Procédé de fabrication d'un motif miniature de demi-teintes sur un substrat électret à partir d'une image de demi-teintes formée d'un agencement bimensionnel de pixels de demi-teintes compris dans un ensemble de demi-teintes allant du clair au sombre, **caractérisé en ce qu'**il comprend les étapes consistant à :

Générer (4) électroniquement un fichier image de demi-teintes composés de pixels, chaque pixel étant défini par des coordonnées bidimensionnelles et une valeur codante de demi-teinte du pixel qui lui est associé,
Convertir (6) le fichier image en un script d'injection, exécutable par un logiciel de commande d'un dispositif d'injection de charges électriques, le script d'injection permettant de reproduire l'image à une échelle réduite en faisant correspondre à chaque pixel un point d'injection de charges électriques sur une surface de réception plane du substrat électret située à un emplacement prédéterminé, le point d'injection étant **caractérisé par** une tension et un temps d'injection dépendant du niveau de demi-teintes du pixel correspondant selon une fonction monotone de conversion du niveau de demi-teinte en tension et temps d'injection, de sorte qu'une carte du potentiel de surface obtenue après injection des charges en les points d'injection reproduise à une échelle réduite l'image de demi-teintes,

Injecter (8) sur la surface plane de réception du substrat électret des charges électriques par un procédé d'injection, adapté au dispositif d'injection et suivant le script d'injection obtenu dans l'étape précédente, ;

mettre en contact (10) le substrat électret ayant la surface de réception inscrite par le potentiel de surface suivant le motif souhaité de charges électriques, avec une dispersion colloïdale pendant une durée de mise en contact suffisamment longue et inférieure ou égale à quinze minutes,

la dispersion colloïdale comportant des nanoparticules colloïdales neutres ou quasi-neutres électriquement et électriquement polarisables sous l'action d'un champ électrique externe ou des nanoparticules chargées, et un milieu de dispersion, sous la forme d'un solvant liquide ou d'un gaz, dans lequel les nanoparticules colloïdales sont dispersées.

2. Procédé de fabrication d'un motif miniature de demi-teintes sur un substrat électret selon la revendication 1, dans lequel le pas d'injection défini comme la distance séparant deux points d'injection immédiatement voisins est choisie de sorte que la taille de l'image miniature est égale à la dimension de l'image exprimée en pixels moins un multipliée par le pas d'injection.

3. Procédé de fabrication d'un motif miniature de demi-teintes selon l'une quelconque des revendications 1 à 2 dans lequel

de l'information est cachée au sein du motif par un procédé de cryptographie selon un algorithme prédéterminé.

4. Procédé de fabrication d'un motif miniature de demi-teintes selon l'une quelconque des revendications 1 à 3, dans lequel pour un type de nanoparticules donné, un type de solvant donné, une concentration de dispersion colloïdale fixée, les tensions d'injection sont modulées dans une plage de valeurs de tension d'injection à laquelle correspond de manière monotone une plage de valeurs de potentiels de surface modulants, la borne inférieure des valeurs absolues des tensions sur la plage de valeurs des tensions d'injection étant choisie pour que la borne inférieure correspondante des valeurs absolues des potentiels de surface de la plage de valeurs de potentiels de surface modulants soit supérieure ou égale à une première valeur seuil de potentiel de surface qui garantit lorsqu'elle est dépassée par des valeurs supérieures que l'assemblage élémentaire de nanoparticules sur le pixel est au minimum visible par microscopie optique en champ sombre tandis que lorsqu'elle n'est pas dépassée, l'assemblage élémentaire de nanoparticules sur le pixel reste invisible par microscopie optique en champ sombre.

5. Procédé de fabrication d'un motif miniature de demi-teintes selon la revendication 4, dans lequel la borne supérieure des valeurs absolues des tensions sur la plage de valeurs des tensions d'injection est choisie pour que la borne supérieure correspondante des valeurs absolues des potentiels de surface de la plage de valeurs de potentiels de surface modulants soit inférieure ou égale à une deuxième valeur seuil de valeur absolue de potentiel de surface qui garantit lorsqu'elle n'est pas dépassée par des valeurs supérieures que l'assemblage élémentaire de nanoparticules sur le pixel réalisé est visible par microscopie optique en champ sombre et invisible en champ clair tandis que lorsqu'elle est dépassée par des valeurs supérieures l'asemblage élémentaire de nanoparticules sur le pixel est visible par microscopie optique en champ clair.

6. Procédé de fabrication d'un motif miniature de demi-teintes selon la revendication 5, dans lequel la borne inférieure des valeurs absolues des tensions sur la plage de valeurs des tensions d'injection est choisie pour que la borne inférieure correspondante des valeurs absolues des potentiels de surface de la plage de valeurs de potentiels de surface modulants soit égale à la première valeur seuil de potentiel de surface qui garantit lorsqu'elle est dépassée que le motif miniature réalisé est visible par microscopie optique en champ sombre tandis que lorsqu'elle n'est pas dépassée par des valeurs supérieures le motif miniature reste invisible par microscopie optique en champ sombre, et la borne supérieure des valeurs absolues des tensions sur la plage de valeurs des tensions d'injection est choisie pour que la borne supérieure correspondante des valeurs absolues des potentiels de surface de la plage de valeurs de potentiels de surface modulants soit égale à la deuxième valeur seuil de la valeur absolue de potentiel de surface qui garantit que lorsqu'elle n'est pas dépassée par des valeurs supéreures, le motif miniature réalisé est visible par microscopie optique en champ sombre et invisible en champ clair tandis que lorsqu'elle est dépassée par des valeurs supérieures le motif miniature est visible au moins partielellement par microscopie optique en champ clair.

7. Procédé de fabrication d'un motif miniature de demi-teintes selon l'une quelconque des revendications 1 à 6, dans lequel les nanoparticules colloïdales possèdent la propriété de convertir un rayonnement dans un spectre proche de l'infrarouge (NIR) en un rayonnement dans un premier spectre du visible.

8. Procédé de fabrication d'un motif miniature de demi-teintes selon l'une quelconque des revendications 1 à 7, dans lequel l'étape d'inscription du potentiel électrique de surface sur la surface de réception du substrat électret suivant un motif de charges est réalisé au choix,

par un procédé d'inscription séquentielle de charges positives et/ou négatives sur le substrat électret compris dans l'ensemble formé par une inscription de charges électriques par un faisceau d'ions focalisés, une inscription de charges électriques par un faisceau d'électrons focalisés, une inscription de charges électriques par microscopie à force atomique (AFM) et une inscription de charges électriques par électrophotographie,

par un procédé d'inscription en parallèle de charges positives et/ou négatives sur le substrat électret compris dans l'ensemble formé par la nano impression électrique et le microcontact électrique.

9. Procédé de fabrication d'un motif miniature de demi-teintes selon l'une quelconque des revendications 1 à 8, dans lequel

le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium ($Si_3N_4$), l'oxyde de silicium ($SiO_2$), le composé $Si_3N_4/SiO_2/Si$ (NOS) ;

les nanoparticules colloïdales sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nano particules colloïdales de base,

les nanoparticules colloïdales de base possédant un coeur solide et le cas échéant une coquille, et étant comprises dans l'ensemble formé par le latex, $SiO_2$, $TiO_2$, $ZrO_2$ ; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni ; Au, Ag, Cu, Pt, et les nanoparticules bi-métalliques ; $WO_3$ ; $NaLnF_4$, les fluorures de lanthanide ($LnF_3$), les oxydes de lanthanides ($Ln_2O_3$), les zirconates, silicates, hydroxydes ($Ln(OH)_3$) et les sulfures d'oxydes dopés ou non avec un ou plusieurs lanthanides différents (Ln désignant un lanthanide), les mélanges de ces composés,

et le milieu dispersant des nanoparticules polarisables est au choix un solvant liquide ou un gaz non polarisant, le solvant liquide étant compris dans l'ensemble formé par le pentane, l'iso-pentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène,

le gaz dispersant non polarisant étant compris dans l'ensemble formé par le diazote $N_2$, l'argon Ar, et l'air.

10. Motif miniature de demi-teintes sur un substrat électret correspondant à une image de demi-teintes formé par un agencement bimensionnel de pixels de demi-teintes compris dans un ensemble de demi-teintes allant du clair au sombre,

Comprenant

un substrat électret,

un ensemble de points d'injection disposés sur une surface libre du substrat électret,

chaque point d'injection du motif miniature étant défini par des coordonnées bidimensionnelles considérées sur la surface et un niveau de demi-teintes compris dans un ensemble de demi-teintes allant du clair au sombre, les coordonnées bidimensionnelles des points d'injection correspondant respectivement aux coordonnées des pixels de l'image, et les niveaux de demi-teintes des points d'injection correspondant respectivement aux niveaux de demi-teintes des pixels associés, de façon à reproduie l'image à une échelle réduite,

sur chaque point d'injection étant fixé un assemblage colloïdale élémentaire de nanoparticules colloïdales, neutres ou quasi-neutres électriquement et électriquement polarisables sous l'action d'un champ électrique externe, piégées sur le substrat au travers de forces diélectrophorétiques, ou un assemblage colloïdale élémentaire de nanoparticules colloïdales chargées piégées sur le substrat au travers de forces éectrophorétiques,

l'assemblage élémentaire ayant une forme et ou une densité caractérisant par ses propriétés optiques réfléchissantes ou émettrices un niveau de demi-teinte de manière unique et différente en étant conforme à la fonction de conversion,

dans lequel le nombre de demi-teintes est supérieur ou égal à 10, de préférence supérieur ou égal à 20, et la résolution des points d'impression est inférieure ou égale à 30nm, de préférence inférieur ou égale à 20nm.

11. Motif miniature de demi-teintes sur un substrat électret selon la revendication 10, dans lequel, lorsque les nanoparticules colloïdales sont neutres ou quasi-neutres électriquement et électriquement polarisables sous l'action d'un champ électrique externe, les assemblages élémentaires des nanoparticules colloïdales sont des assemblages compris dans l'ensemble formé par les assemblages monocouches compacts, les assemblages multicouches compacts, et les assemblages monocouches non compacts.

12. Motif miniature de demi-teintes sur un substrat électret selon l'une quelconque des revendications 10 à 11 dans lequel le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium ($Si_3N_4$), l'oxyde de silicium ($SiO_2$), le composé $Si_3N_4/SiO_2/Si$ (NOS) ;
les nanoparticules colloïdales sensiblement neutres et polarisables électriquement sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nanoparticules colloïdales de base,
les nanoparticules colloïdales de base possédant un coeur solide et le cas échéant une coquille, et étant comprises dans l'ensemble formé par le latex, $SiO_2$, $TiO_2$, $ZrO_2$ ; CdS, CdSe, PbSe, GaAs, GaN, InP, $In_2O_3$, ZnS, ZnO, $MoS_2$, Si, C, ITO ,$Fe_2O_3$, $Fe_3O_4$, Co, Fe-Co, $Fe_3C$, $Fe_5C_2$, Ni ; Au, Ag, Cu, Pt, et les nanoparticules bi-métalliques ; $WO_3$ ; $NaLnF_4$, les fluorures de lanthanide ($LnF_3$), les oxydes de lanthanides ($Ln_2O_3$), les zirconates, silicates, hydroxydes ($Ln(OH)_3$) et les sulfures d'oxydes dopés ou non avec un ou plusieurs lanthanides différents (Ln désignant un lanthanide), les mélanges de ces composés.

13. Motif miniature de demi-teintes sur un substrat électret selon l'une quelconque des revendications 10 à 12 dans lequel les nanoparticules possèdent la propriété de convertir un rayonnement dans un spectre proche de l'infrarouge (NIR) en un rayonnement dans un premier spectre du visible.

14. Motif miniature de demi-teintes sur un substrat électret selon l'une quelconque des revendications 10 à 13 configuré en termes de forme et densité pour être visible par microscopie optique en champ sombre et invisible par microscopie optique en champ clair.

15. Etiquette de marquage anti-contrefaçon et de traçabililité comprenant un motif miniature de demi-teintes sur un substrat électret défini selon l'une quelconque des revendications 10 à 14 ou obtenue par le procédé définie selon l'une quelconque des revendications 1 à 9.

## Patentansprüche

1. Verfahren zur Herstellung eines Miniatur-Halbtonmusters auf einem Elektretsubstrat ausgehend von einem Halbtonbild, das aus einer zweidimensionalen Anordnung von Halbtonpixeln gebildet ist, welche in einer vom Hellen zum Dunklen gehenden Gruppe von Halbtönen umfasst sind, **dadurch gekennzeichnet, dass** es die Schritte umfasst, die bestehen im:

   elektronischen Verwalten (4) einer aus Pixeln aufgebauten Halbton-Bilddatei, wobei jedes Pixel über zweidimensionale Koordinaten und einen Halbton-Codierwert des Pixels definiert ist, welcher demselben zugeordnet ist,
   Umwandeln (6) der Bilddatei in ein Injektionsskript, das über eine Steuerungssoftware einer Vorrichtung zur Injektion von elektrischen Ladungen ausführbar ist, wobei es das Injektionsskript ermöglicht, das Bild in einem verkleinerten Maßstab zu reproduzieren, indem es jedem Pixel einen Punkt zur Injektion von elektrischen Ladungen auf einer ebenen Empfangsfläche des Elektretsubstrats in Entsprechung bringt, der an einer vorbestimmten Stelle liegt, wobei der Injektionspunkt durch eine Injektionsspannung und einen -zeitpunkt gekennzeichnet ist, die nach einer monotonen Funktion zur Umwandlung der Halbtonstufe in Injektionsspannung und -zeitpunkt derart von der Halbtonstufe des entsprechenden Pixels abhängen, dass eine Karte des Oberflächenpotentials, welches nach Injektion der Ladungen an den Injektionspunkten erhalten wird, das Halbtonbild in einem verkleinerten Maßstab reproduziert,
   Injizieren (8), auf der ebenen Empfangsfläche des Elektretsubstrats, der elektrischen Ladungen über ein Injektionsverfahren, welches auf die Injektionsvorrichtung angepasst ist und gemäß dem im vorhergehenden Schritt erhaltenen Injektionsskript,

Kontaktieren (10) des Elektretsubstrats, welches die Empfangsfläche aufweist, die dem gewünschten elektrischen Ladungsmuster gemäß mit dem Oberflächenpotential geprägt ist, mit einer kolloidalen Dispersion über eine Kontaktierungsdauer, die ausreichend lang und kleiner oder gleich fünfzehn Minuten ist, wobei die kolloidale Dispersion elektrisch neutrale oder nahezu neutrale und unter der Einwirkung eines äußeren elektrischen Feldes elektrisch polarisierbare kolloidale Nanopartikel oder geladene Nanopartikel, und ein Dispersionsmedium in der Form eines flüssigen Lösungsmittels oder eines Gases umfasst, in welchem die kolloidalen Nanopartikel dispergiert sind.

2. Verfahren zur Herstellung eines Miniatur-Halbtonmusters auf einem Elektretsubstrat nach Anspruch 1, wobei der Injektionsabstand, der als die Distanz definiert ist, welche zwei unmittelbar benachbarte Injektionspunkte trennt, derart gewählt wird, dass die Größe des Miniaturbildes gleich der in Pixel ausgedrückten Abmessung des Bildes minus eins multipliziert mit dem Injektionsabstand ist.

3. Verfahren zur Herstellung eines Miniatur-Halbtonmusters nach einem der Ansprüche 1 bis 2, wobei über ein Verschlüsselungsverfahren nach einem vorbestimmten Algorithmus Informationen innerhalb des Musters versteckt werden.

4. Verfahren zur Herstellung eines Miniatur-Halbtonmusters nach einem der Ansprüche 1 bis 3, wobei für einen gegebenen Nanopartikeltyp, einen gegebenen Lösungsmitteltyp, eine festgelegte Konzentration der kolloidalen Dispersion, die Injektionsspannungen in einem Injektionsspannungs-Wertebereich moduliert werden, dem in monotoner Weise ein Wertebereich von modulierenden Oberflächenpotentialen entspricht, wobei die untere Grenze der Absolutwerte der Spannungen über den Wertebereich der Injektionsspannungen so gewählt wird, dass die entsprechende untere Grenze der Absolutwerte der Oberflächenpotentiale des Wertebereichs von modulierenden Oberflächenpotentialen größer oder gleich einem ersten Oberflächenpotential-Schwellenwert ist, welcher sicherstellt, dass wenn er von höheren Werten überschritten wird, die elementare Zusammensetzung von Nanopartikeln auf dem Pixel zumindest über optische Dunkelfeldmikroskopie sichtbar ist, wohingegen, wenn er nicht überschritten wird, die elementare Zusammensetzung von Nanopartikeln auf dem Pixel über optische Dunkelfeldmikroskopie unsichtbar bleibt.

5. Verfahren zur Herstellung eines Miniatur-Halbtonmusters nach Anspruch 4, wobei die obere Grenze der Absolutwerte der Spannungen über den Wertebereich der Injektionsspannungen so gewählt wird, dass die entsprechende obere Grenze der Absolutwerte der Oberflächenpotentiale des Wertebereichs von modulierenden Oberflächenpotentialen kleiner oder gleich einem zweiten Oberflächenpotential-Absolutwert-Schwellenwert ist, welcher sicherstellt, dass wenn er nicht von höheren Werten überschritten wird, die elementare Zusammensetzung von Nanopartikeln auf dem ausgeführten Pixel über optische Dunkelfeldmikroskopie sichtbar und im Hellfeld unsichtbar ist, wohingegen, wenn er von höheren Werten überschritten wird, die elementare Zusammensetzung von Nanopartikeln auf dem Pixel über optische Hellfeldmikroskopie sichtbar ist.

6. Verfahren zur Herstellung eines Miniatur-Halbtonmusters nach Anspruch 5, wobei die untere Grenze der Absolutwerte der Spannungen über den Wertebereich der Injektionsspannungen so ausgewählt wird, dass die entsprechende untere Grenze der Absolutwerte der Oberflächenpotentiale des Wertebereichs von modulierenden Oberflächenpotentialen gleich dem ersten Oberflächenpotential-Schwellenwert ist, welcher sicherstellt, dass wenn er überschritten wird, das ausgeführte Miniaturmuster über optische Dunkelfeldmikroskopie sichtbar ist, wohingegen, wenn er nicht von höheren Werten überschritten wird, das Miniaturmuster über optische Dunkelfeldmikroskopie unsichtbar bleibt, und die obere Grenze der Absolutwerte der Spannungen über den Wertebereich der Injektionsspannungen so ausgewählt wird, dass die entsprechende obere Grenze der Absolutwerte der Oberflächenpotentiale des Wertebereichs von modulierenden Oberflächenpotentialen gleich dem zweiten Schwellenwert des Oberflächenpotential-Absolutwerts ist, welcher sicherstellt, dass wenn er nicht von höheren Werten überschritten wird, das ausgeführte Miniaturmuster über optische Dunkelfeldmikroskopie sichtbar und im Hellfeld unsichtbar ist, wohingegen, wenn er von höheren Werten überschritten wird, das Miniaturmuster mindestens teilweise über optische Hellfeldmikroskopie sichtbar ist.

7. Verfahren zur Herstellung eines Miniatur-Halbtonmusters nach einem der Ansprüche 1 bis 6, wobei die kolloidalen Nanopartikel die Eigenschaft besitzen, eine Strahlung in einem Nah-Infrarot-Spektrum (NIR) in eine Strahlung in einem ersten Spektrum des Sichtbaren umzuwandeln.

8. Verfahren zur Herstellung eines Miniatur-Halbtonmusters nach einem der Ansprüche 1 bis 7, wobei der Schritt des Aufprägens des elektrischen Oberflächenpotentials auf die Empfangsfläche des Elektretsubstrats gemäß einem Ladungsmuster wahlweise ausgeführt wird,

über ein Verfahren zum sequentiellen Aufprägen von positiven und/oder negativen Ladungen auf das Elektretsubstrat, welches umfasst ist in der Gruppe gebildet aus einem Aufprägen von elektrischen Ladungen über einen fokussierten Ionenstrahl, einem Aufprägen von elektrischen Ladungen über einen fokussierten Elektronenstrahl, einem Aufprägen von elektrischen Ladungen über atomare Kraftmikroskopie (AFM), und einem Aufprägen von elektrischen Ladungen über Elektrophotographie,

über ein Verfahren zum parallelen Aufprägen von positiven und/oder negativen Ladungen auf das Elektretsubstrat, welches umfasst ist in der Gruppe gebildet aus dem elektrischen Nanoimprint und dem elektrischen Mikrokontakt.

9. Verfahren zur Herstellung eines Miniatur-Halbtonmusters nach einem der Ansprüche 1 bis 8, wobei

das Elektretmaterial ein Material ist, welches umfasst ist in der Gruppe gebildet aus den Polymethylmethacrylaten (PMMA), den Cycloolefin-Copolymeren (CoC), den Polyethylenterephthalaten (PET), den Polydimethylsiloxanen (PDMS), den Polypropylenen (PP), den Polycarbonaten (PC), den Polystyrolen (PS), den Polyvinylchloriden (PVC), den Polytetrafluorethylenen (PFTE), Triglycinsulfat (TGS), Polyvinylidenfluorid (PVDF), Siliziumnitrid ($Si_3N_4$), Siliziumoxid ($SiO_2$), der Verbindung $Si_3N_4/SiO_2/Si$ (NOS);

die kolloidalen Nanopartikel ausgehend von kolloidalen Basis-Nanopartikeln ausgeführte, im Wesentlichen neutral gemachte und elektrisch polarisierbare, über sich selbst oder über Liganden und/oder Ladungen stabilisierte Verbindungen sind, welche physikalische Eigenschaften aufweisen, die umfasst sind in der Gruppe gebildet aus den plasmonischen, leitenden, magnetischen, lumineszenten, katalytischen, elektrochromen, photochromen Eigenschaften,

wobei die kolloidalen Basis-Nanopartikel einen festen Kern und gegebenenfalls eine Schale besitzen, und umfasst sind in der Gruppe gebildet aus Latex, $SiO_2$, $TiO_2$, $ZrO_2$; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni; Au, Ag, Cu, Pt, und den bimetallischen Nanopartikeln; $WO_3$; $NaLnF_4$, den Lanthanidfluoriden ($LnF_3$), den Lanthanidoxiden ($Ln_2O_3$), den Zirkonaten, Silikaten, Hydroxiden ($Ln(OH)_3$) und den Oxidsulfiden, die mit einem oder mehreren verschiedenen Lanthaniden dotiert sind oder nicht (wobei Ln ein Lanthanid bezeichnet), den Mischungen dieser Verbindungen,

und das Dispersionsmedium der polarisierbaren Nanopartikel wahlweise ein flüssiges Lösungsmittel oder ein nicht polarisierendes Gas ist,

wobei das flüssige Lösungsmittel umfasst ist in der Gruppe gebildet aus Pentan, Isopentan, Hexan, Heptan, Octan, Nonan, Decan, Cyclopentan, Cyclohexan, Cycloheptan, Cyclooctan, Cyclohexen, Benzol, Toluol, Methylcyclohexan, Xylol, Mesitylen, Chloroform, Methylenchlorid, Tetrachlorethylen,

wobei das nicht polarisierende Dispersionsgas umfasst ist in der Gruppe gebildet aus Distickstoff $N_2$, Argon Ar, und Luft.

10. Miniatur-Halbtonmuster auf einem Elektretsubstrat, welches einem Halbtonbild entspricht, das durch eine zweidimensionale Anordnung von Halbtonpixeln gebildet ist, welche in einer vom Hellen zum Dunklen gehenden Gruppe von Halbtönen umfasst sind,

umfassend

ein Elektretsubstrat,

eine Gruppe von Injektionspunkten, die auf einer freien Fläche des Elektretsubstrats angeordnet sind,

wobei jeder Injektionspunkt des Miniaturmusters über betreffende zweidimensionale Koordinaten auf der Fläche und eine Halbtonstufe definiert ist, die in einer vom Hellen zum Dunklen gehenden Gruppe von Halbtönen umfasst ist, wobei die zweidimensionalen Koordinaten der Injektionspunkte jeweils den Koordinaten der Pixel des Bildes entsprechen, und die Halbtonstufen der Injektionspunkte jeweils den Halbtonstufen der zugeordneten Pixel entsprechen, um das Bild in einem verkleinerten Maßstab zu reproduzieren,

wobei auf jedem Injektionspunkt eine elementare kolloidale Zusammensetzung von elektrisch neutralen oder nahezu neutralen und unter der Einwirkung eines äußeren elektrischen Feldes elektrisch polarisierbaren kolloidalen Nanopartikeln, die durch dielektrophoretische Kräfte auf dem Substrat festgehalten werden, oder eine elementare kolloidale Zusammensetzung von geladenen kolloidalen Nanopartikeln befestigt ist, die durch elektrophoretische Kräfte auf dem Substrat festgehalten werden,

wobei die elementare Zusammensetzung eine Form und/oder eine Dichte aufweist, die, indem sie der Umwandlungsfunktion konform ist, durch ihre eine Halbtonstufe in eindeutiger und verschiedener Weise reflektierenden oder emittierenden optischen Eigenschaften charakteristisch ist,

wobei die Anzahl von Halbtönen größer oder gleich 10, vorzugsweise größer oder gleich 20 ist, und die Auflösung der Druckpunkte kleiner oder gleich 30 nm, vorzugsweise kleiner oder gleich 20 nm ist.

11. Miniatur-Halbtonmuster auf einem Elektretsubstrat nach Anspruch 10, wobei, wenn die kolloidalen Nanopartikel elektrisch neutral oder nahezu neutral und unter der Einwirkung eines äußeren elektrischen Feldes elektrisch polarisierbar sind, die elementaren Zusammensetzungen der kolloidalen Nanopartikel Zusammensetzungen sind, die umfasst sind in der Gruppe gebildet aus den kompakten einschichtigen Zusammensetzungen, den kompakten mehrschichtigen Zusammensetzungen, und den nicht kompakten einschichtigen Zusammensetzungen.

**12.** Miniatur-Halbtonmuster auf einem Elektretsubstrat nach einem der Ansprüche 10 bis 11, wobei
das Elektretmaterial ein Material ist, welches umfasst ist in der Gruppe gebildet aus den Polymethylmethacrylaten (PMMA), den Cycloolefin-Copolymeren (CoC), den Polyethylenterephthalaten (PET), den Polydimethylsiloxanen (PDMS), den Polypropylenen (PP), den Polycarbonaten (PC), den Polystyrolen (PS), den Polyvinylchloriden (PVC), den Polytetrafluorethylenen (PFTE), Triglycinsulfat (TGS), Polyvinylidenfluorid (PVDF), Siliziumnitrid ($Si_3N_4$), Siliziumoxid ($SiO_2$), der Verbindung $Si_3N_4/SiO_2/Si$ (NOS);
die im Wesentlichen elektrisch neutralen und polarisierbaren kolloidalen Nanopartikel ausgehend von kolloidalen Basis-Nanopartikeln ausgeführte, im Wesentlichen neutral gemachte elektrisch und polarisierbare, über sich selbst oder über Liganden und/oder Ladungen stabilisierte Verbindungen sind, welche physikalische Eigenschaften aufweisen, die umfasst sind in der Gruppe gebildet aus den plasmonischen, leitenden, magnetischen, lumineszenten, katalytischen, elektrochromen, photochromen Eigenschaften,
wobei die kolloidalen Basis-Nanopartikel einen festen Kern und gegebenenfalls eine Schale besitzen und umfasst sind in der Gruppe gebildet aus Latex, $SiO_2$, $TiO_2$, $ZrO_2$; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni; Au, Ag, Cu, Pt, und den bimetallischen Nanopartikeln; $WO_3$; $NaLnF_4$, den Lanthanidfluoriden ($LnF_3$), den Lanthanidoxiden ($Ln_2O_3$), den Zirkonaten, Silikaten, Hydroxiden ($Ln(OH)_3$) und den Oxidsulfiden, die mit einem oder mehreren verschiedenen Lanthaniden dotiert sind oder nicht (wobei Ln ein Lanthanid bezeichnet), den Mischungen dieser Verbindungen.

**13.** Miniatur-Halbtonmuster auf einem Elektretsubstrat nach einem der Ansprüche 10 bis 12, wobei
die Nanopartikel die Eigenschaft besitzen, eine Strahlung in einem Nah-Infrarot-Spektrum (NIR) in eine Strahlung in einem ersten Spektrum des Sichtbaren umzuwandeln.

**14.** Miniatur-Halbtonmuster auf einem Elektretsubstrat nach einem der Ansprüche 10 bis 13, das in Bezug auf Form und Dichte so ausgebildet ist, dass es über optische Dunkelfeldmikroskopie sichtbar, und über optische Hellfeldmikroskopie unsichtbar ist.

**15.** Etikett zur Fälschungsschutzkennzeichnung und Rückverfolgbarkeit, welches ein Miniatur-Halbtonmuster auf einem definierten Elektretsubstrat nach einem der Ansprüche 10 bis 14 umfasst oder nach dem definierten Verfahren nach einem der Ansprüche 1 bis 9 erhalten wird.

## Claims

**1.** Method for manufacturing a miniature half-tone pattern on an electret substrate from a half-tone image formed by a two-dimensional assembly of half-tone pixels included in an assembly of half-tones ranging from light to dark, **characterised in that** it comprises steps consisting of:

Electrically generating (4) a half-tone image file composed of pixels, each pixel being defined by two-dimensional coordinates and a half-tone coding value of the pixel to which it is associated,
Converting (6) the image file into an injection script, executable through a control software of a device for injection of electric charges, the injection script allowing an image to be reproduced in small-scale by matching an electrical charge injection point to each pixel on a flat reception surface of the electret substrate situated in a pre-determined place, the point of injection being **characterised by** a voltage and a time of injection depending on the level of half-tones of the corresponding pixel according to a conversion monotonic function of the level of half-tone voltage and time of injection, so that a map of the obtained surface potential after injection of the charges into the injection points reproduces the half-tone image in small-scale,

Injecting (8), on the flat reception surface of the electret substrate, electric charges by a method of injection, adapted to the injection device and following the injection script obtained in the preceding step;
contacting (10) the electret substrate having the reception surface inscribed by the surface potential following the desired pattern of electric charges, with a colloidal dispersion for a duration of contact that is sufficiently long and less than or equal to fifteen minutes,
the colloidal dispersion comprising colloidal nanoparticles that are electrically neutral or quasi-neutral and electrically polarisable under the influence of an external electric field or charged nanoparticles, and a dispersion medium, in the form of a liquid solvent or a gas, in which the colloidal nanoparticles are dispersed.

2. Method for manufacturing a miniature half-tone pattern on an electret substrate according to claim 1, wherein the injection step defined as the distance separating two immediately neighbouring injection points is chosen so that the size of the miniature image is equal to the dimensions of the image expressed in pixels minus one multiplied by the injection step.

3. Method for manufacturing a miniature half-tone pattern according to any one of claims 1 or 2, wherein information is hidden within the pattern using a cryptographic method according to a predetermined algorithm.

4. Method for manufacturing a miniature half-tone pattern according to any one of claims 1 to 3, wherein, for a given type of nanoparticles, a given type of solvent, a fixed concentration of colloidal dispersion, the injection voltages are modulated in a range of injection voltage values to which a range of modulated surface potential values correspond in a uniform manner, the lower limit of the absolute voltage values on the range of injection voltage values being chosen so that the lower limit corresponding to the absolute values of surface potential of the range of modulated surface potential values is greater than or equal to a first threshold value of surface potential which guarantees that, when it is exceeded by higher values, the elementary assembly of nanoparticles on the pixel is at least visible through dark-field microscopy, whereas when it is not exceeded, the elementary assembly of nanoparticles remains invisible through dark-field microscopy.

5. Method for manufacturing a miniature half-tone pattern according to claim 4, wherein the upper limit of the absolute values of voltage of the range of injection tension values is chosen so that the upper limit corresponding to the absolute values of surface potential of the range of values of modulated surface potential are lower or equal to a second absolute threshold value of absolute surface potential which guarantees that, when it is not exceeded by higher values, the elementary assembly of nanoparticles on the fabricated pixel is visible through dark-field microscopy and invisible in light-field, whereas when it is exceeded by higher values, the elementary assembly of nanoparticles on the pixel is visible through light-field microscopy.

6. Method for manufacturing a miniature half-tone pattern according to claim 5, wherein the lower limit of absolute values of voltage of the range of injection tension values is chosen so that the lower limit corresponding to the absolute values of surface potential of the range of values of modulated surface potential is equal to the first threshold value of surface potential which guarantees that, when it is exceeded, the fabricated miniature pattern is visible through dark-field microscopy, whereas when it is not exceeded by higher values the miniature pattern remains invisible through dark-field microscopy, and
the upper limit of absolute values of voltage of the range of injection voltages is chosen so that the upper limit corresponding to the absolute values of modulated surface potential is equal to the second absolute threshold value of surface potential which guarantees that, when it is not exceeded by higher values, the fabricated miniature pattern is visible through dark-field microscopy and invisible in light-field, whereas when it is not exceeded by higher values the miniature pattern is at least partially visible through light-field microscopy.

7. Method for manufacturing a miniature half-tone pattern according to any one of claims 1 to 6, wherein the colloidal nanoparticles possess the ability to convert radiation in a near infra-red spectrum (NIR) into radiation in a first visible spectrum.

8. Method for manufacturing a miniature half-tone pattern according to one of claims 1 to 7, wherein the step of inscribing electric surface potential onto the reception surface of the electret substrate following a pattern of charges is implemented either,
by a method of sequential inscription of positive and/or negative charges on the electret substrate included in the assembly formed by an inscription of electric charges by a beam of focused ions, an inscription of electric charges by a beam of focused electrons, an inscription of electric charges by atomic force microscopy (AFM) and an inscription of electric charges by electrophotography,
by a method of simultaneous inscription of positive and/or negative electrical charges on the electret substrate included in the assembly formed by the electric nano-printing and the electric microcontact.

9. Method for manufacturing a miniature half-tone pattern according to any one of claims 1 to 8, wherein the electret material is a material included in the assembly formed by poly(methyl methacrylate) (PMMA), cyclic olefin copolymer (CoC), polyethylene terephthalate (PET), polydimethylsiloxane (PDMS), polypropylene (PP), polycarbonate (PC), polystyrene (PS), polyvinyl chloride (PVC), polytetrafluoroethylene (PFTE), triglycine sulphate (TGS), polyvinylidene fluoride (PVDF), silicon nitride ($Si_3N_4$), silicon dioxide ($SiO_2$), the compound $Si_3N_4/SiO_2/Si$ (NOS);

the colloidal nanoparticles are compounds stabilised by themselves or by ligands and/or charges, having physical properties included in the assembly formed by plasmonic, conductive, magnetic, luminescent, catalytic, electrochromic, and photochromic properties made substantially neutral and electrically polarisable, formed by colloidal base nanoparticles,

the colloidal base nanoparticles having a solid centre and, where appropriate, a shell, and being included in the assembly formed by latex, $SiO_2$, $TiO_2$, $ZrO_2$; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni; Au, Ag, Cu, Pt, and bi-metallic nanoparticles; $WO_3$; $NaLnF_4$, lanthanide fluoride ($LnF_3$), lanthanide oxide ($Ln_2O_3$), zirconate, silicate, hydroxide ($Ln(OH)_3$) and doped or non-doped sulphurised oxide with one or several different lanthanides (Ln designating a lanthanide), mixtures of these compounds,

and the dispersing medium of the polarisable nanoparticles is either a liquid solvent or a non-polarising gas,

the liquid solvent being included in the assembly formed by pentane, iso-pentane, hexane, heptane, octane, nonane, decane, cyclopentane, cyclohexane, cycloheptane, cyclooctane, cyclohexene, benzene, toluene, methylcyclohexane, xylene, mesitylene, chloroform, methylene chloride, tetrachloroethylene,

the dispersing non-polarising gas being included in the assembly formed by dinitrogen $N_2$, argon Ar, and air.

10. Miniature half-tone pattern on an electret substrate corresponding to a half-tone image formed by a two-dimensional arrangement of half-tone pixels included in an assembly of half-tones ranging from light to dark,
Comprising
an electret substrate,
an assembly of injection points arranged on a free surface of the electret substrate,
each injection point of the miniature pattern being defined by considered two-dimensional coordinates on the surface and a level of half-tones included in an assembly of half-tones ranging from light to dark, the two-dimensional coordinates of the injection points respectively corresponding to the pixels of the image, and the half-tone levels of the injection points respectively corresponding to the half-tone levels of the associated pixels, in order to reproduce the image in small-scale,
an elementary colloidal assembly of colloidal nanoparticles, which are electrically neutral or quasi-neutral and electrically polarisable under the influence of an external electric field, trapped on the substrate through dielectrophoretic forces, or an elementary colloidal assembly of charged colloidal nanoparticles trapped on the substrate through electrophoretic forces being fixed on each injection point,
the elementary assembly having a shape and/or a density that characterises, by its reflective or transmissive light properties, a unique and different half-tone level by conforming to the conversion function,
in which the number of half-tones is greater than or equal to 10, preferably greater than or equal to 20, and the resolution of the printing points is lower than or equal to 30nm, preferably lower than or equal to 20nm.

11. Miniature half-tone pattern on an electret substrate according to claim 10, wherein, when the colloidal nanoparticles which are electrically neutral or quasi-neutral and electrically polarisable under the influence of an external electric field, the elementary assemblies of colloidal nanoparticles are assemblies included in the assembly formed by compact single-layer assemblies, compact multilayer assemblies, and non-compact single-layer assemblies.

12. Miniature half-tone pattern on an electret substrate according to any one of claims 10 to 11, wherein
the electret material is a material included in the assembly formed by poly(methyl methacrylate) (PMMA), cyclic olefin copolymer (CoC), polyethylene terephthalate (PET), polydimethylsiloxane (PDMS), polypropylene (PP), polycarbonate (PC), polystyrene (PS), polyvinyl chloride (PVC), polytetrafluoroethylene (PFTE), triglycine sulphate (TGS), polyvinylidene fluoride (PVDF), silicon nitride ($Si_3N_4$), silicon dioxide ($SiO_2$), the compound $Si_3N_4/SiO_2/Si$ (NOS);
the substantially neutral and electrically polarisable colloidal nanoparticles are compounds stabilised by themselves or by ligands and/or charges, having physical properties included in the assembly formed by plasmonic, conductive, magnetic, luminescent, catalytic, electrochromic and photochromic properties made substantially neutral and electronically polarisable, formed by colloidal base nanoparticles,
the colloidal base nanoparticles having a solid core and, where appropriate, a shell, and being included in the assembly formed by latex, $SiO_2$, $TiO_2$, $ZrO_2$; CdS, CdSe, PbSe, GaAs, GaN, InP, $In_2O_3$, ZnS, ZnO, $MoS_2$, Si, C, ITO, $Fe_2O_3$, $Fe_3O_4$, Co, Fe-Co, $Fe_3C$, $Fe_5C_2$, Ni; Au, Ag, Cu, Pt, and bi-metallic nanoparticles; $WO_3$; $NaLnF_4$, lanthanide fluoride ($LnF_3$), lanthanide oxide ($Ln_2O_3$), zirconate, silicate, hydroxide ($Ln(OH)_3$) and doped or non-doped sulphurised oxide with one or several different lanthanides (Ln designating a lanthanide), mixtures of these compounds.

13. Miniature half-tone pattern on an electret substrate according to any one of claims 10 to 12, wherein the nanoparticles have the ability to convert radiation in a near infra-red spectrum (NIR) into radiation in a first visible spectrum.

14. Miniature half-tone pattern on an electret substrate according to any one of claims 10 to 13, configured in terms of form and density to be visible through dark-field microscopy and invisible through light-field microscopy.

15. Anti-counterfeit and anti-traceability label comprising a miniature half-tone pattern on an electret substrate defined according to any one of claims 10 to 14 or obtained using the method defined according to any one of claims 1 to 9.

2

- 4 -

- 6 -

Fig. 1

- 8 -

- 10 -

Fig. 2A

EP 3 152 152 B1

Champ sombre

Traitement Infographique

*Fig. 2B*

Champ clair

Traitement
infographique

Fig. 3A

Champ sombre

Traitement
Infographique

Fig. 3B

Fig. 4

Fig. 5

Champ clair

20 µm

Traitement Infographique

*Fig. 6A*

EP 3 152 152 B1

262 Champ sombre

266

Traitement infographique

Fig. 6B

268

Fig. 7A

282

Champ sombre

284

Traitement
infographique

Fig. 7B

286

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013071960 A1

- FR 1352092

**Littérature non-brevet citée dans la description**

- **W. SELE.** Lithography-Free, Self-Aligned Inkjet Printing with Sub-Hundred-Nanometer Resolution. *Advanced Materials,* Avril 2005, vol. 17 (8), 997-1001
- **T. KRAUS et al.** Nanoparticle printing with single-particle résolution. *Nature Nanotechnology,* Septembre 2007, vol. 2 (9), 570-576

- *NANOTECHNOLOGY,* 19 Juillet 2011, vol. 22 (32), 325603
- **CHAD R BARRY et al.** Printing nanoparticles from the liquid and gas phases using nanoxerography; Printing nanoparticles from the liquid and gas phases using nanoxerography. *NANOTECHNOLOGY,* 01 Octobre 2003, vol. 14, 1057-1063